# EUROPEAN PATENT APPLICATION

(11) **EP 4 496 337 A1**
(43) Date of publication of application: **22.01.2025**
(21) Application number: 23770376.4
(22) Date of filing: 28.02.2023
(51) Int. Cl.: H04N 25/771, H01L 27/146, H04N 25/585, H04N 25/70

(54) **SOLID-STATE IMAGING DEVICE AND ELECTRONIC APPARATUS**

(30) Priority: 16.03.2022 JP 2022040923
(71) Applicant: Sony Semiconductor Solutions Corporation, Atsugi-shi, Kanagawa 243-0014 (JP)
(72) Inventor: IIDA Satoko, Atsugi-shi, Kanagawa 243-0014 (JP); HATTORI Yuki, Atsugi-shi, Kanagawa 243-0014 (JP); NAKASHIMA Yoshimitsu, Atsugi-shi, Kanagawa 243-0014 (JP); SHIRAI Yuki, Atsugi-shi, Kanagawa 243-0014 (JP); NAKANISHI Shunta, Atsugi-shi, Kanagawa 243-0014 (JP)
(74) Representative: Müller Hoffmann & Partner
(86) International application number: PCT/JP2023/007209
(87) International publication number: WO 2023/176418

(57) **Abstract**

The present disclosure relates to a solid-state imaging device and an electronic device capable of realizing a pixel structure including two photoelectric converters having different sensitivities and two capacitive elements that accumulate charges generated by the photoelectric converters and expanding a dynamic range.

The solid-state imaging device includes a unit pixel including a first photoelectric converter having a first sensitivity, a second photoelectric converter having a second sensitivity lower than the first sensitivity, a first capacitive element connected to the first photoelectric converter, and a second capacitive element connected to the second photoelectric converter. The present disclosure can be applied to, for example, a solid-state imaging device or the like.

## Description

### TECHNICAL FIELD

The present disclosure relates to a solid-state imaging device and an electronic device, and more particularly, to a solid-state imaging device and an electronic device capable of realizing a pixel structure including two photoelectric converters having different sensitivities and two capacitive elements that accumulate charges generated by the photoelectric converters and expanding a dynamic range.

### BACKGROUND ART

As a structure for expanding a dynamic range of a pixel, there is a solid-state imaging device including a unit pixel including a large pixel and a small pixel having different sensitivities and including a capacitive element that accumulates a charge generated in the small pixel (see, for example, Patent Document 1). Furthermore, in order to expand a dynamic range, a solid-state imaging device including a capacitive element that accumulates photocharges overflowing from a photodiode in each pixel has been proposed (see, for example, Patent Document 2).

### CITATION LIST

### PATENT DOCUMENT

Patent Document 1: WO 2020/121724 A
Patent Document 2: Japanese Patent Application Laid-Open No. 2006-245522

### SUMMARY OF THE INVENTION

### PROBLEMS TO BE SOLVED BY THE INVENTION

In order to add a capacitive element that accumulates photocharges overflowing from a photodiode as disclosed in Patent Document 2 to a unit pixel having a large pixel and a small pixel having different sensitivities and including a capacitive element that accumulates charges generated in the small pixel as disclosed in Patent Document 1, two capacitive elements are required in the unit pixel. When two capacitive elements are simply provided in a unit pixel, the capacitive elements are divided into two, leading to a decrease in dynamic range.

The present disclosure has been made in view of such a situation, and an object of the present disclosure is to realize a pixel structure including two photoelectric converters having different sensitivities and two capacitive elements that accumulate charges generated by the photoelectric converters, and to expand a dynamic range.

### SOLUTIONS TO PROBLEMS

A solid-state imaging device according to a first aspect of the present disclosure includes a unit pixel including a first photoelectric converter having a first sensitivity, a second photoelectric converter having a second sensitivity lower than the first sensitivity, a first capacitive element connected to the first photoelectric converter, and a second capacitive element connected to the second photoelectric converter.

An electronic device according to a second aspect of the present disclosure includes a solid-state imaging device including a unit pixel including a first photoelectric converter having a first sensitivity, a second photoelectric converter having a second sensitivity lower than the first sensitivity, a first capacitive element connected to the first photoelectric converter, and a second capacitive element connected to the second photoelectric converter.

In the first and second aspects of the present disclosure, a first photoelectric converter having a first sensitivity, a second photoelectric converter having a second sensitivity lower than the first sensitivity, a first capacitive element connected to the first photoelectric converter, and a second capacitive element connected to the second photoelectric converter are provided in a unit pixel.

The solid-state imaging device or the electronic device may be an independent device or a module incorporated in another device.

### BRIEF DESCRIPTION OF DRAWINGS

Fig. 1 is a diagram illustrating a schematic configuration of a solid-state imaging device to which the technology of the present disclosure is applied.
Fig. 2 is a diagram illustrating a first circuit configuration example of a unit pixel.
Fig. 3 is a plan view illustrating an arrangement example of a photoelectric converter and a pixel transistor.
Fig. 4 is a cross-sectional view of a unit pixel.
Fig. 5 is a plan view showing a pixel transistor arrangement under wiring patterns of Figs. 11 to 15.
Fig. 6 is a cross-sectional view of the unit pixel taken along line Z-Z' in Fig. 7.
Fig. 7 is a plan view illustrating a cross-sectional line of the cross-sectional view of Fig. 6.
Fig. 8 is a cross-sectional view of a unit pixel including a pixel isolation portion different from that in Fig. 4.
Fig. 9 is a plan view illustrating formation positions of the pixel isolation portion in Fig. 8.
Fig. 10 is a plan view illustrating an arrangement example of color filters.
Fig. 11 is a plan view illustrating a wiring pattern example of a metal wiring line of a first wiring layer.
Fig. 12 is a plan view illustrating a wiring pattern example of a metal wiring line of a second wiring layer.
Fig. 13 is a plan view illustrating a wiring pattern example of a metal wiring line of a third wiring layer.
Fig. 14 is a plan view illustrating a wiring pattern example of a metal wiring line of a fourth wiring layer.
Fig. 15 is a plan view illustrating a wiring pattern example of a metal wiring line of a fifth wiring layer.
Fig. 16 is a timing chart illustrating a first drive control of the unit pixel.
Fig. 17 is a timing chart illustrating a second drive control of the unit pixel.
Fig. 18 is a timing chart illustrating a third drive control of the unit pixel.
Fig. 19 is a diagram illustrating characteristics of a normal mode and a priority mode.
Fig. 20 is a diagram illustrating a result of measuring characteristics of a normal mode and a priority mode under a plurality of temperature conditions.
Fig. 21 is a diagram illustrating an effect of a comb-teeth shaped wiring capacitance.
Fig. 22 is a diagram illustrating an effect of a comb-teeth shaped wiring capacitance.
Fig. 23 is a diagram illustrating a second circuit configuration example of the unit pixel.
Fig. 24 is a plan view illustrating a pixel transistor arrangement example of a second circuit configuration example of the unit pixel.
Fig. 25 is a timing chart illustrating a drive control of the second circuit configuration example of the unit pixel.
Fig. 26 is a diagram illustrating a third circuit configuration example of the unit pixel.
Fig. 27 is a plan view illustrating a pixel transistor arrangement example of a third circuit configuration example of the unit pixel.
Fig. 28 is a diagram illustrating a fourth circuit configuration example of the unit pixel.
Fig. 29 is a diagram illustrating a configuration example of a vertical drive unit.
Fig. 30 is a diagram illustrating a usage example of an image sensor.
Fig. 31 is a block diagram illustrating a configuration example of an imaging device as an electronic device to which the technology of the present disclosure is applied.
Fig. 32 is a block diagram illustrating an example of a schematic configuration of a vehicle control system.
Fig. 33 is an illustrative diagram illustrating an example of installation positions of a vehicle exterior information detection unit and an imaging section.

### MODE FOR CARRYING OUT THE INVENTION

Hereinafter, modes for carrying out the technique of the present disclosure (hereinafter, referred to as embodiments) will be described with reference to the accompanying drawings. Explanation will be made in the following order.
1. Schematic configuration example of solid-state imaging device
2. First circuit configuration example of unit pixel
3. Arrangement example of photoelectric converter and pixel transistor
4. Cross-sectional view of unit pixel
5. Wiring pattern example of each wiring layer
6. First drive control example
7. Second drive control example (normal mode)
8. Third drive control example (priority mode)
9. Characteristics of normal mode and priority mode
10. Effect of comb-tooth shaped wiring capacitance
11. Second circuit configuration example of unit pixel
12. Drive control example of second circuit configuration example
13. Third circuit configuration example of unit pixel
14. Fourth circuit configuration example of unit pixel
15. Configuration example of vertical drive unit
16. Usage example of image sensor
17. Application example to electronic device
18. Application example to mobile body

Note that, in the drawings referred to in the following description, the same or similar parts are denoted by the same or similar reference signs, and redundant description will be omitted as appropriate. The drawings are schematic, and the relationship between the thickness and the plane dimension, the ratio of the thickness of each layer, and the like are different from the actual ones. Furthermore, the drawings may include portions having different dimensional relationships and ratios.

Furthermore, definitions of directions such as up and down in the following description are merely definitions for convenience of description, and do not limit the technical idea of the present disclosure. For example, when an object is observed by rotating the object by 90°, the upper and lower sides are read by converting into left and right, and when an object is observed by rotating the object by 180°, the upper and lower sides are read by inverting.

In addition, + and - added to the P-type and the N-type in the following description mean a semiconductor region having a relatively higher or lower impurity concentration than a semiconductor region in which + and - are not added, respectively. However, the semiconductor regions denoted with the same P and N do not mean that the impurity concentrations of the respective semiconductor regions are exactly the same.

### <1. Schematic configuration example of solid-state imaging device>

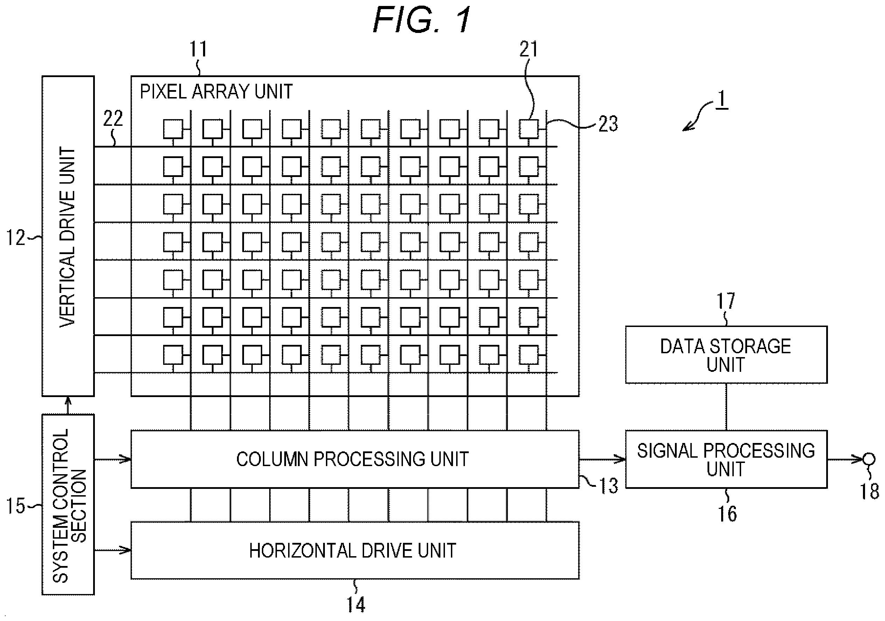

Fig. 1 is a diagram illustrating a schematic configuration of a solid-state imaging device to which the technology of the present disclosure is applied.

The solid-state imaging device 1 in Fig. 1 illustrates a configuration of a CMOS image sensor which is a type of solid-state imaging device of an X-Y address system, for example. The CMOS image sensor is an image sensor manufactured by applying or partially using a CMOS process.

The solid-state imaging device 1 includes a pixel array unit 11 and a peripheral circuit unit. The peripheral circuit unit includes, for example, a vertical drive unit 12, a column processing unit 13, a horizontal drive unit 14, and a system control section 15.

The solid-state imaging device 1 further includes a signal processing unit 16 and a data storage unit 17. The signal processing unit 16 and the data storage unit 17 may be mounted on the same substrate as the pixel array unit 11, the vertical drive unit 12, and the like, or may be disposed on another substrate. Furthermore, each processing of the signal processing unit 16 and the data storage unit 17 may be executed by an external signal processing unit provided in a semiconductor chip different from the solid-state imaging device 1, for example, a digital signal processor (DSP) circuit or the like.

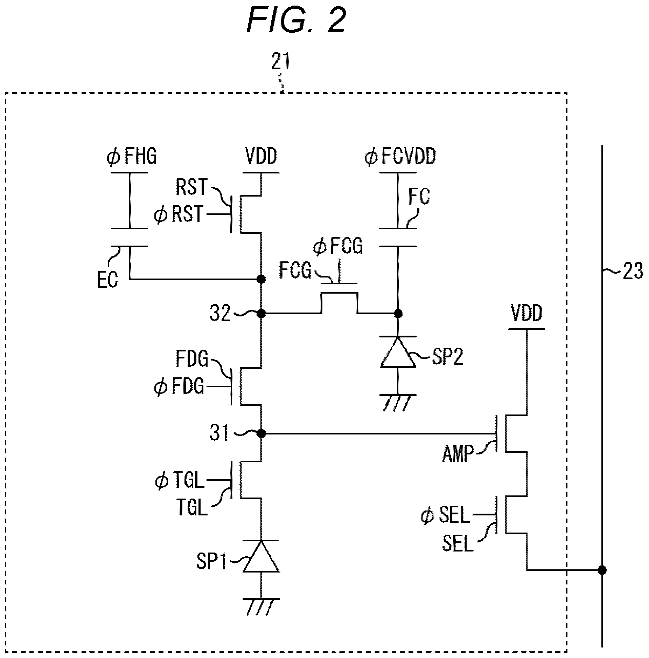

In the pixel array unit 11, unit pixels 21 having photoelectric conversion elements that generate and accumulate photocharges corresponding to the amount of received light are two-dimensionally arranged in a matrix in the row direction and the column direction. Here, the row direction refers to a pixel row of the pixel array unit 11, that is, an array direction in the horizontal direction, and the column direction refers to a pixel column of the pixel array unit 11, that is, an array direction in the vertical direction. A specific circuit configuration example of the unit pixel 21 will be described later with reference to Fig. 2 and the like.

Furthermore, in the pixel array unit 11, a pixel drive wiring 22 as a row signal line is wired along the row direction for each pixel row, and a vertical signal line 23 as a column signal line is wired along the column direction for each pixel column. The pixel drive wiring 22 transmits a drive signal for driving when reading a signal from the unit pixel 21. In Fig. 1, the pixel drive wiring 22 is illustrated as one line, but the number is not limited to one. One end of the pixel drive wiring 22 is connected to an output terminal corresponding to each row of the vertical drive unit 12.

The vertical drive unit 12 includes a shift register, an address decoder, and the like and drives each unit pixel 21 of the pixel array unit 11 at the same time for all the pixels, in units of rows, or the like. The vertical drive unit 12 configures a drive unit that controls the operation of each unit pixel 21 of the pixel array unit 11 together with the system control section 15. Although a specific configuration of the vertical drive unit 12 is not illustrated, the vertical drive unit generally includes two scanning systems of a reading scanning system and a sweeping scanning system.

The read scanning system selectively scans the unit pixels 21 in the pixel array unit 11 sequentially on a row-by-row basis in order to read signals from the unit pixels 21. The signal read from the unit pixel 21 is an analog signal. The sweep scanning system performs sweep scanning on a read row on which the read scanning is to be performed by the read scanning system earlier than the read scanning by an exposure time.

Through the sweep scanning by the sweeping scanning system, unnecessary charges are swept out from the photoelectric converters of the unit pixels 21 in the read row, whereby the photoelectric converters of the respective unit pixels 21 are reset. Then, by sweeping out (resetting) unnecessary charges by the sweeping scanning system, a so-called electronic shutter operation is performed. Here, the electronic shutter operation refers to operation of discharging the charge of the photoelectric converter and newly starting exposure (starting accumulation of charges).

The signal read by the read operation of the read scanning system corresponds to the amount of the received light after the immediately preceding read operation or electronic shutter operation. Then, a period from a read timing in the immediately preceding read operation or a sweep timing in the electronic shutter operation to a read timing in the current read operation is an exposure period in the unit pixel 21.

The signal output from each unit pixel 21 in the pixel row selectively scanned by the vertical drive unit 12 is input to the column processing unit 13 through each of the vertical signal lines 23 for every pixel column. The column processing unit 13 performs predetermined signal processing on the signal output from each unit pixel 21 of the selected row through the vertical signal line 23 for each unit pixel column of the pixel array unit 11, and temporarily holds the pixel signal after the signal processing.

Specifically, the column processing unit 13 performs, as signal processing, at least noise removal processing, for example, correlated double sampling (CDS) processing or double data sampling (DDS) processing. For example, in the CDS processing, fixed pattern noise unique to the pixel, such as reset noise or threshold variation of an amplification transistor in the unit pixel, is removed. The column processing unit 13 may have, for example, an analog-digital (AD) conversion function in addition to the noise removal processing, and convert an analog pixel signal into a digital signal and output the digital signal.

The horizontal drive unit 14 includes a shift register, an address decoder, and the like, and sequentially selects a unit circuit corresponding to the pixel column in the column processing unit 13. When the selective scanning is performed by the horizontal drive unit 14, the pixel signal subjected to the signal processing for every unit circuit in the column processing unit 13 is sequentially output.

The system control section 15 includes a timing generator that generates various timing signals and the like, and performs drive control of the vertical drive unit 12, the column processing unit 13, the horizontal drive unit 14, and the like on the basis of various timings generated by the timing generator.

The signal processing unit 16 has at least an arithmetic processing function, and performs various signal processing such as arithmetic processing on the pixel signal output from the column processing unit 13. The data storage unit 17 temporarily stores data necessary for signal processing in the signal processing unit 16. The pixel signal subjected to the signal processing in the signal processing unit 16 is converted into a predetermined format and output from an output unit 18 to the outside of the device.

### <2. First circuit configuration example of unit pixel>

Fig. 2 is a diagram illustrating a circuit configuration example of a unit pixel 21 provided in the pixel array unit 11. The circuit configuration example of the unit pixel 21 in Fig. 2 is also referred to as a first circuit configuration example to be distinguished from other circuit configuration examples described later.

The unit pixel 21 includes a first photoelectric converter SP1 and a second photoelectric converter SP2 which are two photoelectric converters having different sensitivities. The first photoelectric converter SP1 is a photoelectric converter having a large photoelectric conversion region and high sensitivity (high sensitivity), and the second photoelectric converter SP2 is a photoelectric converter having a small photoelectric conversion region as compared with the first photoelectric converter SP1 and lower sensitivity (low sensitivity) than the first photoelectric converter SP1.

The unit pixel 21 further includes a first transfer transistor TGL, a first FD unit 31, a switching transistor FDG, a second FD unit 32, a second transfer transistor FCG, a reset transistor RST, a first capacitive element EC, a second capacitive element FC, an amplification transistor AMP, and a selection transistor SEL. Each pixel transistor of the first transfer transistor TGL, the switching transistor FDG, the second transfer transistor FCG, the reset transistor RST, the amplification transistor AMP, and the selection transistor SEL is configured by an N-type MOS transistor (MOS FET).

The first photoelectric converter SP1 includes, for example, a photodiode, and generates and accumulates a charge (signal charge) corresponding to the amount of received light. The anode terminal of the first photoelectric converter SP1 is grounded, and the cathode terminal thereof is connected to the first FD unit 31 through the first transfer transistor TGL.

When turned on by the first transfer drive signal ϕTGL supplied to the gate electrode, the first transfer transistor TGL reads the charge generated by the first photoelectric converter SP1 and transfers the charge to the first FD unit 31.

The first FD unit 31 holds the charge read from the first photoelectric converter SP1 or the second photoelectric converter SP2. The first FD unit 31 includes a diffusion layer capacitance formed by a diffusion layer (high-concentration semiconductor region) in the semiconductor substrate.

The switching transistor FDG turns on and off the connection between the first FD unit 31 and the second FD unit 32 according to a capacitance switching signal ϕFDG supplied to the gate electrode, and switches the conversion efficiency. For example, when the amount of incident light is high illuminance, the switching transistor FDG is turned on, and the first FD unit 31 and the second FD unit 32 are connected. It is therefore possible to accumulate more electric charges when luminous intensity is high. On the other hand, when the amount of incident light is low illuminance, the switching transistor FDG is turned off, and the second FD unit 32 is disconnected from the first FD unit 31. It is therefore possible to increase conversion efficiency.

The second FD unit 32 holds the charge read from the first photoelectric converter SP1 or the second photoelectric converter SP2. The second FD unit 32 includes a diffusion layer capacitance formed by a diffusion layer (high-concentration semiconductor region) in the semiconductor substrate.

The first capacitive element EC is an accumulation capacitance that accumulates charges overflowing from the first FD unit 31 and the second FD unit 32. Although details will be described later, the first capacitive element EC can be configured by, for example, a wiring capacitance formed in a multilayer wiring layer. One electrode of the first capacitive element EC is connected to the second FD unit 32, and the other electrode is connected to a predetermined voltage ϕFHG that changes according to the drive timing.

When turned on by a reset drive signal ϕRST supplied to the gate electrode, the reset transistor RST discharges the charges accumulated in the first FD unit 31 and the second FD unit 32 to the drain (power supply voltage VDD), thereby resetting the potentials of the first FD unit 31 and the second FD unit 32. In a case where the reset transistor RST is turned on, the switching transistor FDG is also turned on at the same time.

The second photoelectric converter SP2 includes, for example, a photodiode, and generates and accumulates a charge (signal charge) corresponding to the amount of received light. The second photoelectric converter SP2 has an anode terminal grounded and a cathode terminal connected to one of the second transfer transistors FCG and one of the second capacitive elements FC.

The second capacitive element FC is an accumulation capacitance that accumulates the charge generated by the second photoelectric converter SP2. Although details will be described later, the second capacitive element FC can be configured by, for example, metal-oxide-semiconductor (MOS) capacitance. The MOS capacitance is more broadly referred to as a metal-insulator-semiconductor (MIS) capacitance. One electrode of the second capacitive element FC is connected to the cathode terminal of the second photoelectric converter SP2 and the drain of the second transfer transistor FCG, and the other electrode is connected to a predetermined voltage ϕFCVDD that changes according to the drive timing.

Here, a magnitude relationship of the capacitances of the first FD unit 31, the second FD unit 32, the first capacitive element EC, and the second capacitive element FC will be described. The capacitances of the first FD unit 31 and the second FD unit 32, which are diffusion layer capacitances formed by the diffusion layer in the semiconductor substrate, are smaller than the capacitance of the first capacitive element EC formed by a wiring capacitance other than the diffusion layer capacitance. The capacitances are formed such that the second FD unit 32 is larger than the first FD unit 31, the first capacitive element EC is larger than the second FD unit 32, and the second capacitive element FC is larger than the first capacitive element EC, that is, a relationship of (the first FD unit 31) < (the second FD unit 32) < (the first capacitive element EC) < (the second capacitive element FC) is met.

The accumulated charge amounts of the first FD unit 31, the second FD unit 32, the first capacitive element EC, and the second capacitive element FC can be, for example, about 0.5 to 1.5 fF in the accumulated charge amount of the first FD unit 31, about 1.0 to 3.0 fF in the accumulated charge amount of the second FD unit 32, about 2.5 to 7.5 fF in the accumulated charge amount of the first capacitive element EC, and about 5.0 to 20.0 fF in the accumulated charge amount of the second capacitive element FC within a range in which the above-described magnitude relationship is not lost. However, depending on the configuration of the capacitance, the capacitance can be increased or decreased beyond the range of this example.

In addition, the capacitances per unit area of the first capacitive element EC and the second capacitive element FC are compared, and then the capacitances of the first capacitive element EC and the second capacitive element FC have a relationship that the second capacitive element FC is larger than the first capacitive element EC, that is, (the first capacitive element EC) < (the second capacitive element FC).

When turned on by a second transfer drive signal ϕFCG supplied to the gate electrode, the second transfer transistor FCG reads the charge generated by the second photoelectric converter SP2 and transfers the charge to the first FD unit 31 and the second FD unit 32. When the second transfer transistor FCG is turned on, the switching transistor FDG is also turned on.

The amplification transistor AMP outputs a signal corresponding to the potential of the first FD unit 31. That is, the amplification transistor AMP configures a source follower circuit with a load MOS transistor (not illustrated) as a constant current source connected through the vertical signal line 23, and a signal VSL indicating a level corresponding to the charge accumulated in the first FD unit 31 is output from the amplification transistor AMP to the column processing unit 13 (Fig. 1) through the selection transistor SEL. In a case where the switching transistor FDG is on, the amplification transistor AMP outputs a signal corresponding to the potentials of the first FD unit 31 and the second FD unit 32.

When turned on by a selection drive signal ϕSEL supplied to the gate electrode, the selection transistor SEL selects the unit pixel 21 and outputs the signal VSL generated in the unit pixel 21 to the column processing unit 13 through the vertical signal line 23.

The first transfer drive signal ϕTGL, the second transfer drive signal ϕFCG, the capacitance switching signal ϕFDG, the reset drive signal ϕRST, and the selection drive signal ϕSEL are pulse signals in which a Hi level state becomes an active state (ON state) and a Lo level state becomes an inactive state (OFF state). The first transfer drive signal ϕTGL, the second transfer drive signal ϕFCG, the capacitance switching signal ϕFDG, the reset drive signal ϕRST, and the selection drive signal ϕSEL are supplied from the vertical drive unit 12 through the pixel drive wiring 22 in Fig. 1.

As described above, the unit pixel 21 includes the first photoelectric converter SP1 having the first sensitivity, the second photoelectric converter SP2 having the second sensitivity lower than the first sensitivity, the first capacitive element EC connected to the first photoelectric converter SP1 and accumulating the charge generated by the first photoelectric converter SP1, and the second capacitive element FC connected to the second photoelectric converter SP2 and accumulating the charge generated by the second photoelectric converter SP2. Although detailed driving will be described later, the unit pixel 21 can output three or more different signals with a single exposure.

### <3. Arrangement example of photoelectric converter and pixel transistor>

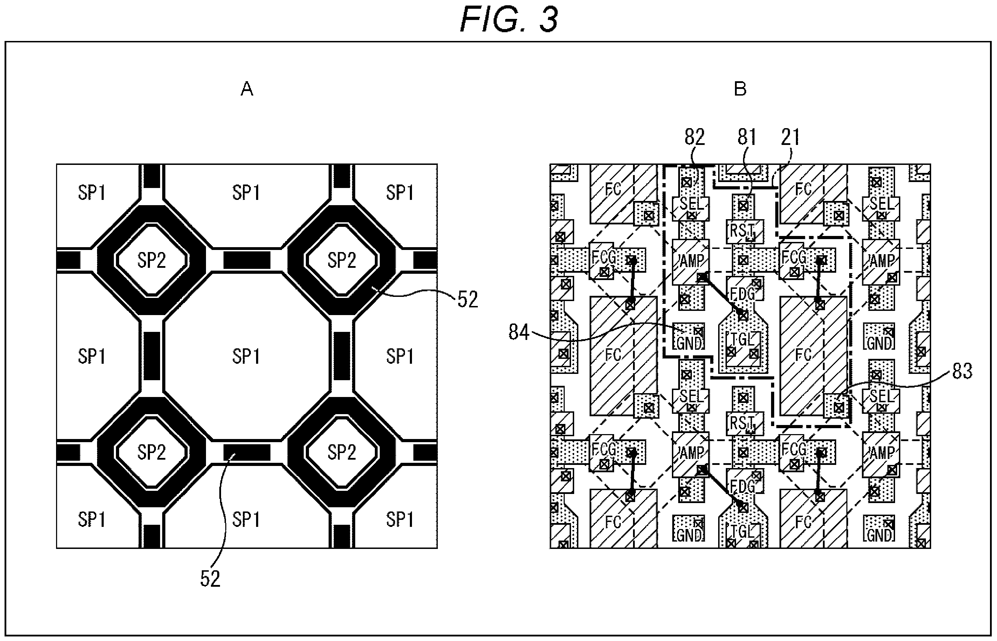

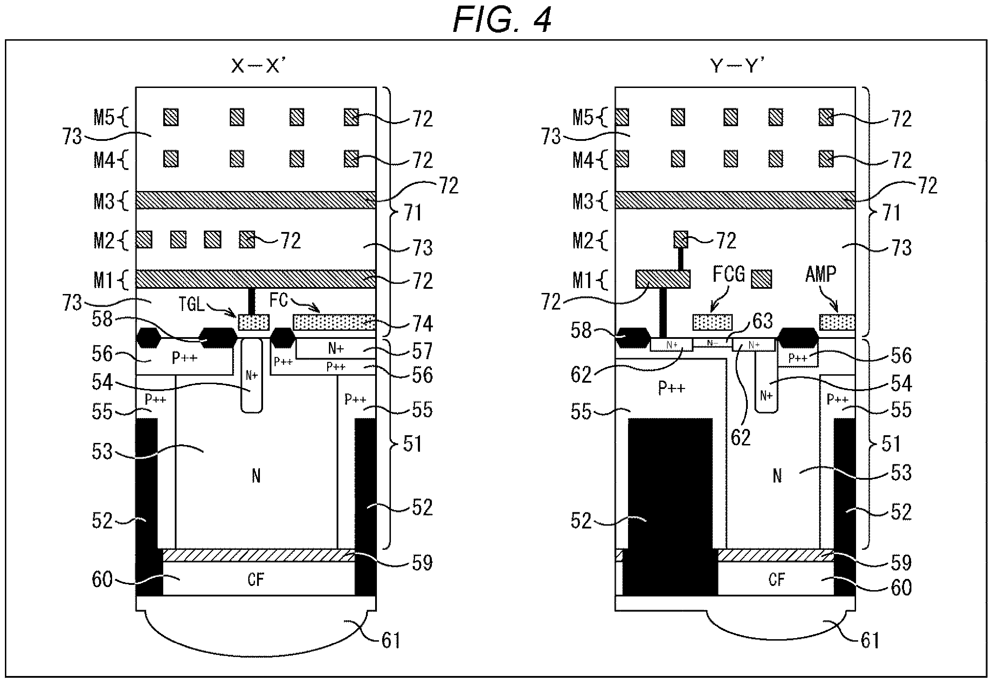

A of Fig. 3 is a plan view illustrating an arrangement example of the first photoelectric converter SP1 and the second photoelectric converter SP2 of the unit pixel 21. A of Fig. 3 is a plan view of a semiconductor substrate 51 (Fig. 4) on which the first photoelectric converter SP1 and the second photoelectric converter SP2 are formed as viewed from a back surface side which is the light incident surface side on which light is incident.

A of Fig. 3 illustrates the arrangement of the first photoelectric converter SP1 and the second photoelectric converter SP2 in the pixel array unit 11 with one first photoelectric converter SP1 as the center.

As illustrated in A of Fig. 3, the first photoelectric converter SP1 having a large photoelectric conversion region and the second photoelectric converter SP2 having a photoelectric conversion region smaller than the first photoelectric converter SP1 are two-dimensionally arranged in a matrix in the pixel array unit 11. The second photoelectric converter SP2 is disposed adjacent to a diagonal position of a corner of the first photoelectric converter SP1 having a substantially rectangular shape.

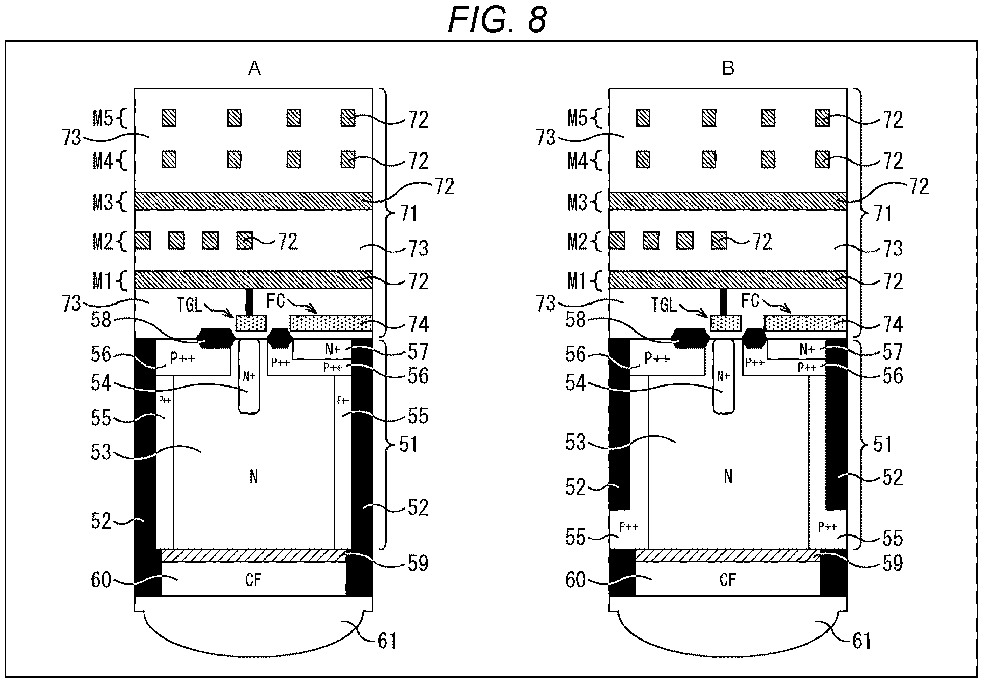

A pixel isolation portion 52 electrically isolated from the adjacent first photoelectric converter SP1 or second photoelectric converter SP2 is formed on the outer peripheral portion of each of the first photoelectric converter SP1 and the second photoelectric converter SP2. In other words, each of the first photoelectric converter SP1 and the second photoelectric converter SP2 is electrically isolated from the other region by the pixel isolation portion 52. The pixel isolation portion 52 has, for example, a trench structure dug from the back surface side of the semiconductor substrate 51 as described later with reference to Fig. 4, a trench structure dug from the front surface side of the semiconductor substrate 51 as described later with reference to Fig. 8, or a structure penetrating the semiconductor substrate 51.

Hereinafter, in order to facilitate understanding, a pixel region corresponding to the first photoelectric converter SP1 in the unit pixel 21 will be referred to as a large pixel, and a pixel region corresponding to the second photoelectric converter SP2 will be referred to as a small pixel.

B of Fig. 3 is a plan view illustrating a pixel transistor arrangement example of the first circuit configuration example of the unit pixel 21. B of Fig. 3 is a plan view of the semiconductor substrate 51 as viewed from a front surface side opposite to the light incident surface side. In B of Fig. 3, a region corresponding to one unit pixel 21 is indicated by a one-dot chain line, but the unit pixels 21 having the same structure are repeatedly arranged in the row direction and the column direction.

The first transfer transistor TGL, the switching transistor FDG, and the reset transistor RST are arranged in a first active region 81 in the vertical direction (pixel column direction). In addition, the second transfer transistor FCG is also formed in the first active region 81. The amplification transistor AMP and the selection transistor SEL are formed adjacent to a second active region 82 in the vertical direction (pixel column direction).

A third active region 83 configures one electrode (N+ type semiconductor region 57 in Fig. 4) of the second capacitive element FC including a MOS capacitance, and the other electrode is formed on the opposed upper side. A fourth active region 84 forms a contact region for supplying a ground voltage (GND) to the semiconductor substrate 51.

### <4. Cross-sectional view of unit pixel>

Fig. 4 illustrates a cross-sectional view of the unit pixel 21.

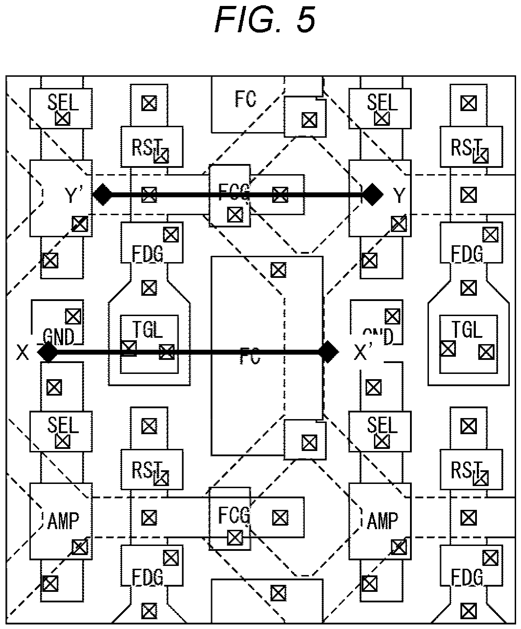

The cross-sectional view on the left side of Fig. 4 illustrates a cross-sectional view of a large pixel portion (first photoelectric converter SP1 portion), and the cross-sectional view on the right side of Fig. 4 illustrates a cross-sectional view of a small pixel portion (second photoelectric converter SP2 portion). The cross-sectional view of the large pixel portion on the left side corresponds to the cross-sectional view taken along line X-X' in Fig. 5, and the cross-sectional view of the small pixel portion on the right side corresponds to the cross-sectional view taken along line Y-Y' in Fig. 5.

The unit pixel 21 is formed on the semiconductor substrate 51 containing, for example, silicon (Si) as a semiconductor material. On the upper surface of the semiconductor substrate 51, the pixel transistors of the first transfer transistor TGL, the switching transistor FDG, the second transfer transistor FCG, the reset transistor RST, the amplification transistor AMP, and the selection transistor SEL, and the multilayer wiring layer 71 are formed.

In most of the pixels of the semiconductor substrate 51, an N type semiconductor region 53 and an N+ type semiconductor region 54 configuring the photoelectric conversion region of the first photoelectric converter SP1 are formed. The N+ type semiconductor region 54 is a region having a higher concentration than the N type semiconductor region 53.

The pixel isolation portion 52 and a P++ type semiconductor region 55 are formed at a boundary portion with another pixel adjacent to the large pixel. A P++ type semiconductor region 56 as a pinning layer for suppressing dark current is formed on a front surface side of the semiconductor substrate 51. The pixel isolation portion 52 is formed by embedding a metal material such as tungsten (W) by, for example, a CVD method.

The second capacitive element FC including the first transfer transistor TGL and the MOS capacitance is formed on the front surface side of the semiconductor substrate 51 of the large pixel portion. Furthermore, an element isolation region 58 including shallow trench isolation (STI) is also formed. One of the pair of electrodes of the second capacitive element FC includes an N+ type semiconductor region 57 formed in the semiconductor substrate 51, and the other electrode includes a polysilicon electrode 74 formed in the multilayer wiring layer 71 so as to face the N+ type semiconductor region 57.

On the substrate on the back surface side of the semiconductor substrate 51, a color filter (CF) 60 is formed through an insulating film 59 formed of one or a plurality of oxide films or the like, and an on-chip lens 61 is further formed on the color filter 60.

The multilayer wiring layer 71 includes a plurality of wiring layers M and an interlayer insulating film 73 therebetween. In the present embodiment, the number of stacked wiring layers M is five, and the multilayer wiring layer 71 is configured by a first wiring layer M1 to a fifth wiring layer M5 and the interlayer insulating film 73, but the number of stacked wiring layers M is not limited to five. A metal wiring line 72 is formed in a predetermined wiring pattern in each of the first wiring layer M1 to the fifth wiring layer M5. The metal wiring line 72 contains, for example, a material such as tungsten (W), aluminum (Al), copper (Cu), or gold (Au). The metal wiring lines 72 of the respective wiring layers M may contain the same material or different materials. Even in the same wiring layer, the metal wiring line 72 of a different material may be used depending on the region.

On the other hand, an N type semiconductor region 53 and an N+ type semiconductor region 54 configuring the photoelectric conversion region of the second photoelectric converter SP2 are formed in the semiconductor substrate 51 of the small pixel portion. The N+ type semiconductor region 54 is a region having a higher concentration than the N type semiconductor region 53.

The pixel isolation portion 52 and the P++ type semiconductor region 55 are formed at a boundary portion with another pixel adjacent to the small pixel. The second transfer transistor FCG, the amplification transistor AMP, and the element isolation region 58 are formed on the front surface side of the semiconductor substrate 51. The two N+ type semiconductor regions 62 configure a source and a drain of the second transfer transistor FCG, and a region where a channel region between the source and the drain is formed is formed of the N- type semiconductor region 63 having a lower concentration than the N+ type semiconductor region 62.

On the substrate on the back surface side of the semiconductor substrate 51, a color filter (CF) 60 is formed through an insulating film 59 formed of one or a plurality of oxide films or the like, and an on-chip lens 61 is further formed on the color filter 60.

The color filters 60 have the same color of red, green, or blue in units of unit pixels 21 including large pixels and small pixels, and are arranged in a Bayer array, for example.

As described above, in the unit pixel 21, since the first photoelectric converter SP1 is formed of a large photoelectric conversion region and the second photoelectric converter SP2 is formed of a photoelectric conversion region smaller than the first photoelectric converter SP1, the first photoelectric converter SP1 has higher sensitivity than the second photoelectric converter SP2.

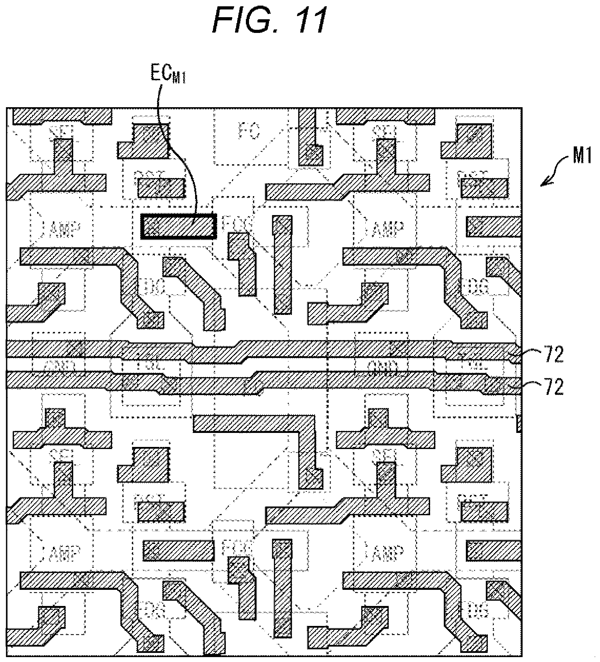

As will be described later with reference to Figs. 11 to 14, the first capacitive element EC is configured by wiring capacitances formed in the first wiring layer M1 to a fourth wiring layer M4. On the other hand, since the second capacitive element FC is configured by the MOS capacitance including the N+ type semiconductor region 57 and the polysilicon electrode 74, the first capacitive element EC and the second capacitive element FC are arranged in different layers.

The flatness of the metal wiring line 72 and the interlayer insulating film 73 of the wiring layer M configuring the multilayer wiring layer 71 is inferior to the film thicknesses of the N+ type semiconductor region 57 and the polysilicon electrode 74 of the second capacitive element FC. Conversely, since the film thickness of the second capacitive element FC can be controlled with high accuracy, the second capacitive element FC has high variation resistance. Since the second capacitive element FC for high illuminance is greatly affected by characteristic fluctuation due to sensitivity variation, it is preferable to apply the wiring capacitance in which unevenness is likely to occur in flatness not to a capacitance for a small pixel but to a capacitance for a large pixel. Therefore, with use of the wiring capacitance for the first capacitive element EC and use of the MOS capacitance for the second capacitive element FC, the influence of variation can be minimized, whereby noise can be suppressed and a high SN ratio can be realized.

In the present embodiment, the first capacitive element EC is configured by a wiring capacitance, and the second capacitive element FC is configured by a MOS capacitance. However, other configurations may be adopted. For example, the first capacitive element EC may be configured with a MOS capacitance, and the second capacitive element FC may be configured with a metal-insulator-metal (MIM) capacitance. Alternatively, both the first capacitive element EC and the second capacitive element FC may be configured with the MIM capacitance. In a case where the MIM capacitance is used, a larger capacitance can be secured. Furthermore, the first capacitive element EC and the second capacitive element FC are not limited to the MOS capacitance and the MIM capacitance, and may be configured with a metal-oxide-metal (MOM) capacitance, a poly-insulator-poly (PIP) capacitance, or a deep trench capacitor (DTC) capacitance such as a trench DRAM or a Si Capacitor.

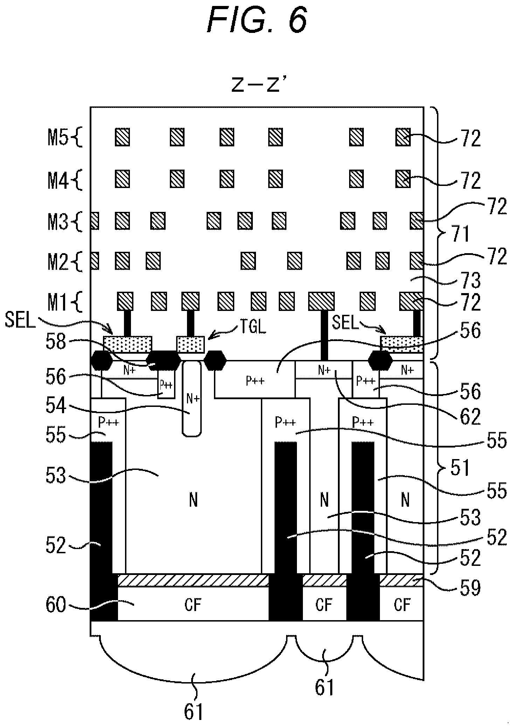

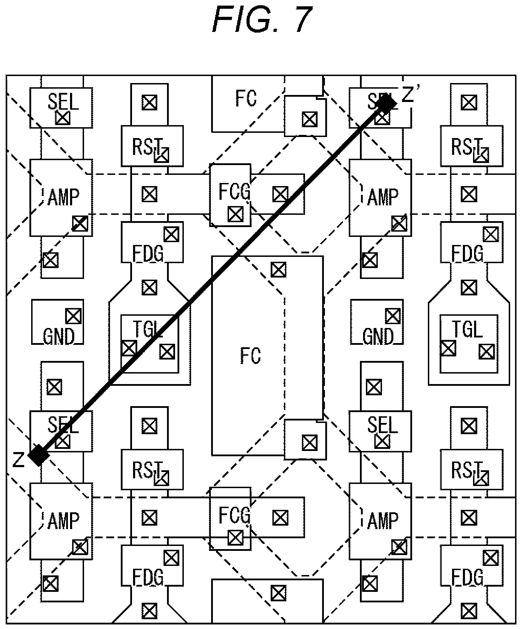

Fig. 6 is a cross-sectional view taken across the majority pixel portion (first photoelectric converter SP1 portion) and the minority pixel portion (second photoelectric converter SP2 portion), and is a cross-sectional view taken along line Z-Z' in Fig. 7. Fig. 7 is a plan view illustrating a cross-sectional line of the cross-sectional view of Fig. 6. In Fig. 6, the same reference numerals are given to portions corresponding to those in Fig. 4, and thus the description of Fig. 6 is omitted. As illustrated in Figs. 6 and 7, the large pixel (first photoelectric converter SP1) and the small pixel (second photoelectric converter SP2) are formed adjacent to each other in the pixel array unit 11.

In the pixel structure illustrated in Figs. 4 and 6, the pixel isolation portion 52 has a trench structure dug from the back surface side of the semiconductor substrate 51 to a depth in the middle of the substrate. However, the pixel isolation portion 52 may have a trench structure dug from the front surface side of the semiconductor substrate 51 to a depth in the middle of the substrate, or may have a structure penetrating the semiconductor substrate 51 to isolate the first photoelectric converter SP1 and the second photoelectric converter SP2.

A of Fig. 8 is a cross-sectional view illustrating a configuration example in which the pixel isolation portion 52 penetrates the semiconductor substrate 51, and B of Fig. 8 is a cross-sectional view illustrating a configuration example in which the pixel isolation portion 52 has a trench structure dug from the front surface side of the semiconductor substrate 51 to a depth in the middle of the substrate. A and B of Fig. 8 correspond to cross-sectional views taken along line X-X' of Fig. 5.

The cross-sectional view in A of Fig. 8 is different from the cross-sectional view taken along line X-X' on the left side of Fig. 4 in that the pixel isolation portion 52 is configured to penetrate from the front surface to the back surface of the semiconductor substrate 51, and the other points are common. The pixel isolation portion 52 penetrating the semiconductor substrate 51 may be formed by digging from the front surface side of the semiconductor substrate 51 or may be formed by digging from the back surface side. Furthermore, the cross-sectional view of B of Fig. 8 is different in that the pixel isolation portion 52 is formed from the front surface side of the semiconductor substrate 51 to a depth in the middle of the substrate, and the other points are common. The P++ type semiconductor region 55 is formed at a pixel boundary portion on the back surface side of the semiconductor substrate 51 where the pixel isolation portion 52 is not formed.

In a case where the pixel isolation portion 52 has a structure penetrating the semiconductor substrate 51 or a structure dug from the front surface side of the semiconductor substrate 51, also in the cross-sectional view taken along line Z-Z' illustrated in Fig. 6, the pixel isolation portion 52 has a structure penetrating the semiconductor substrate 51 or a structure dug from the front surface side of the semiconductor substrate 51.

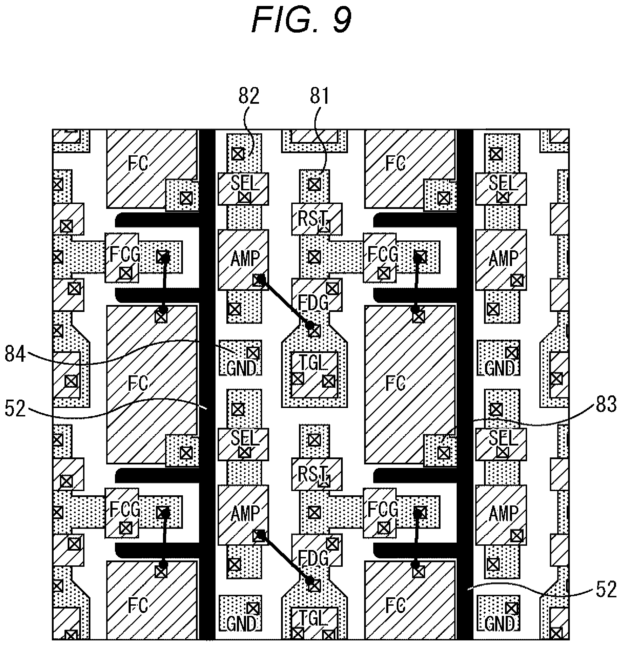

Fig. 9 is a plan view illustrating a formation position of the pixel isolation portion 52 in a case where the pixel isolation portion 52 is formed by a method of digging from the front surface side of the semiconductor substrate 51.

In a case where the pixel isolation portion 52 is formed by a method of digging from the front surface side of the semiconductor substrate 51, the pixel isolation portion 52 can be formed in a region other than the first active region 81, the second active region 82, the third active region 83, and the fourth active region 84. For example, as illustrated in Fig. 9, the pixel isolation portion 52 can be formed in a region outside the third active region 83 configuring one electrode (the N+ type semiconductor region 57 in Fig. 4) of the second capacitive element FC and the first active region 81 in which the second transfer transistor FCG is formed.

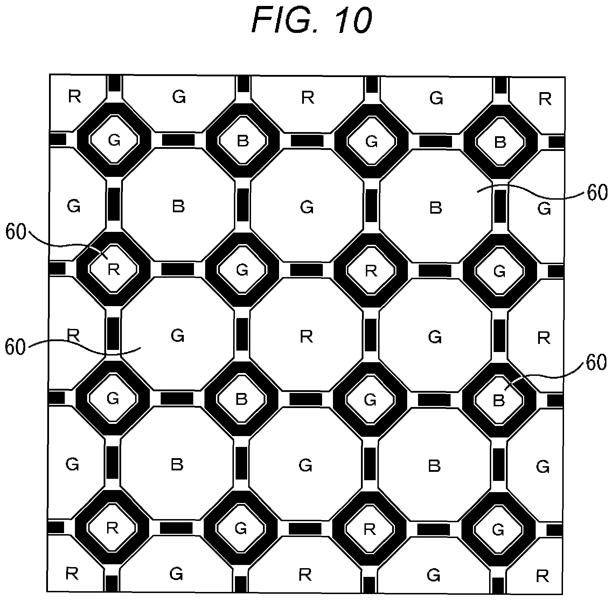

Fig. 10 is a plan view illustrating an arrangement example of the color filters (CF) 60.

For example, as illustrated in Fig. 10, the color filters 60 can be arranged in a Bayer array in which red (R), green (G), or blue (B) is arranged for each unit pixel 21 including a large pixel and a small pixel. The Bayer array is an array in which combinations of "R", "G", "G", and "B" are repeatedly arranged in the row direction and the column direction as a repeating unit. In Fig. 10, color filters 60 that transmit red wavelengths are formed in large pixels and small pixels described as "R", color filters 60 that transmit green wavelengths are formed in large pixels and small pixels described as "G", and color filters 60 that transmit blue wavelengths are formed in large pixels and small pixels described as "B". Then, four unit pixels 21 of 2x2 in which the color filters 60 of "R", "G", "G", and "B" are arranged are repeatedly arrayed in the row direction and the column direction as a repeating unit.

In addition, although not illustrated, the color filter 60 may be a color filter array ("RYYCy" array) in which four unit pixels 21 including 2x2, which are repeating units, are a combination of "R", "Y", "Y", and "Cy". The "Y" color filter 60 is a color filter that transmits a yellow wavelength, and the "Cy" color filter 60 is a color filter that transmits a cyan wavelength.

Alternatively, furthermore, the color filter 60 may be a color filter array ("RCCB" array) in which four unit pixels 21 including 2 × 2, which are repeating units, are a combination of "R", "C", "C", and "B". The "C" (clear) color filter 60 is a color filter that transmits the entire wavelength of visible light, and may be referred to as "W" (white).

Alternatively, the color filter 60 may be a color filter array ("RCCG" array) in which four unit pixels 21 including 2 × 2, which are repeating units, are a combination of "R", "C", "C", and "G".

Furthermore, in the above-described example, an example has been described in which the color filters 60 of the large pixel and the small pixel configuring the unit pixel 21 have the same color, but the color filters 60 of the large pixel and the small pixel configuring the unit pixel 21 may have different colors. For example, the colors of the color filters 60 of the large pixel and the small pixel may be different, and the color filter array of each of the large pixel and the small pixel may be the above-described "RGGB", "RYYCy", "RCCB", or "RCCG" array.

### <5. Wiring pattern example of each wiring layer>

The wiring patterns of the first wiring layer M1 to the fifth wiring layer M5 will be described with reference to Figs. 11 to 15. In Figs. 11 to 15, only a part of the metal wiring line 72 of each wiring layer M is denoted by a reference sign.

Fig. 5 is a plan view illustrating a pixel transistor arrangement under the wiring patterns of Figs. 11 to 15. The line X-X' in Fig. 5 is a line segment corresponding to the cross-sectional view of the large pixel portion on the left side of Fig. 4, and the line Y-Y' in Fig. 5 is a line segment corresponding to the cross-sectional view of the small pixel portion on the right side of Fig. 4.

Fig. 11 illustrates a wiring pattern example of the metal wiring line 72 formed in the first wiring layer M1. Among the metal wiring lines 72 formed in the first wiring layer M1, a metal wiring line EC_{M1} is a wiring configuring a part of the first capacitive element EC. The metal wiring line EC_{M1} is connected to the diffusion layer configuring the second FD unit 32 on the lower side, and is connected to a metal wiring line EC_{M2} of a second wiring layer M2 on the upper side.

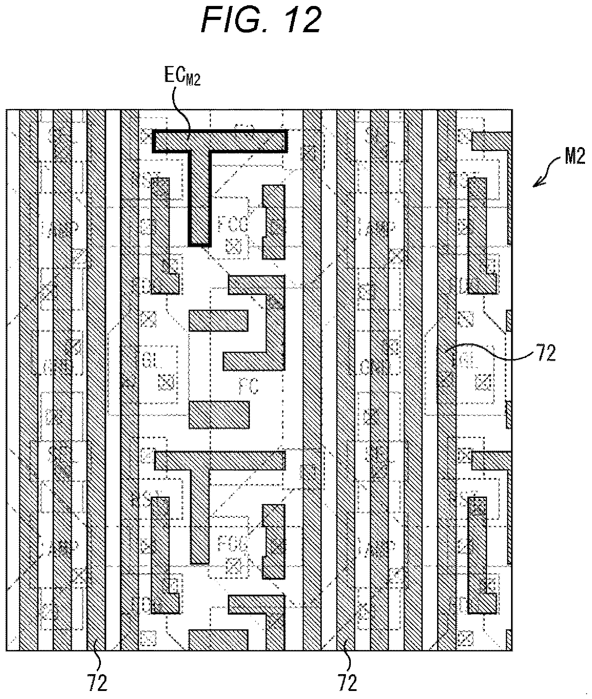

Fig. 12 illustrates a wiring pattern example of the metal wiring line 72 formed in the second wiring layer M2. Among the metal wiring lines 72 formed in the second wiring layer M2, the metal wiring line EC_{M2} is a wiring configuring a part of the first capacitive element EC. The metal wiring line EC_{M2} is connected to the metal wiring line EC_{M1} of the first wiring layer M1 on the lower side, and is connected to a metal wiring line EC_{M3} of a third wiring layer M3 on the upper side.

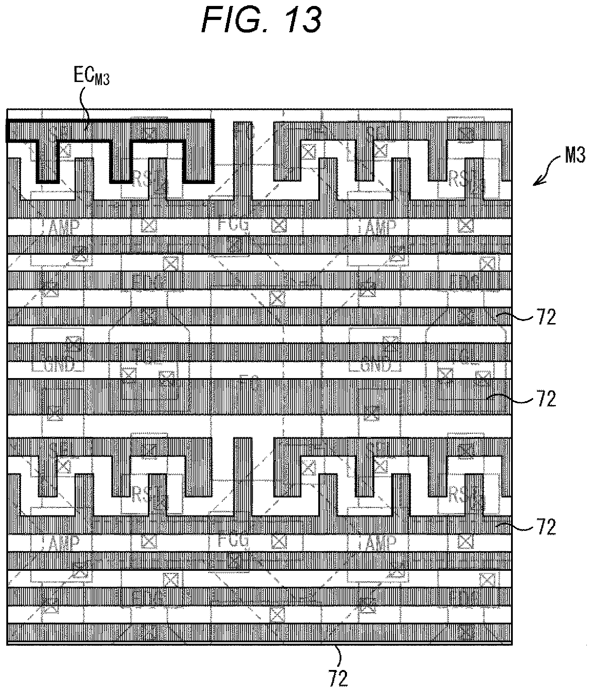

Fig. 13 illustrates a wiring pattern example of the metal wiring line 72 formed in the third wiring layer M3. Among the metal wiring lines 72 formed in the third wiring layer M3, the metal wiring line EC_{M3} is a wiring configuring a part of the first capacitive element EC. The metal wiring line EC_{M3} is connected to the metal wiring line EC_{M2} of the second wiring layer M2 on the lower side, and is connected to a metal wiring line EC_{M4} of the fourth wiring layer M4 on the upper side.

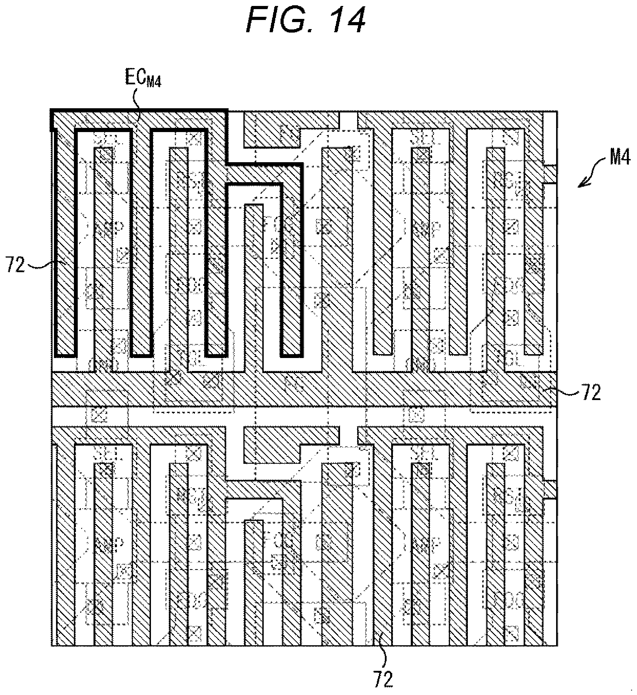

Fig. 14 illustrates a wiring pattern example of the metal wiring line 72 formed in the fourth wiring layer M4. Among the metal wiring lines 72 formed in the fourth wiring layer M4, the metal wiring line EC_{M4} is a wiring configuring a part of the first capacitive element EC. The metal wiring line EC_{M4} is connected to the metal wiring line EC_{M3} of the third wiring layer M3 on the lower side. The metal wiring line EC_{M3} of the third wiring layer M3 and the metal wiring line EC_{M4} of the fourth wiring layer M4 are formed in a comb tooth shape.

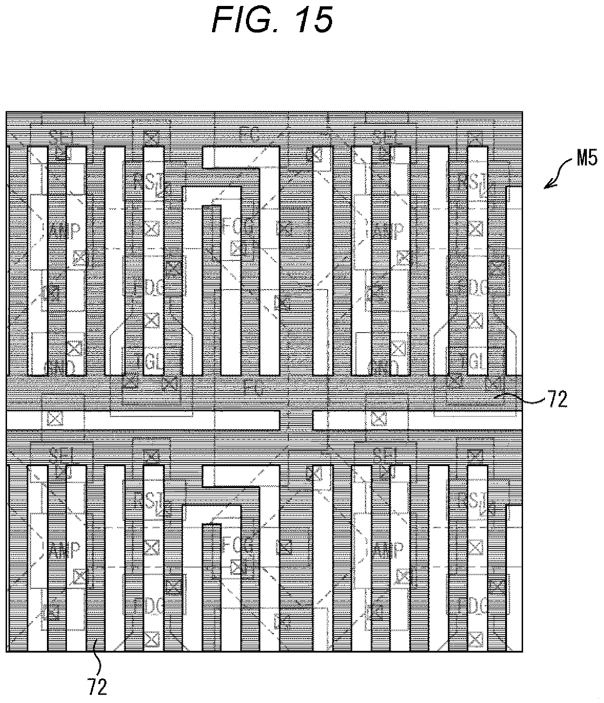

Fig. 15 illustrates a wiring pattern example of the metal wiring line 72 formed in the fifth wiring layer M5. The power supply voltage VDD is supplied to the metal wiring line 72 of the fifth wiring layer M5. With arrangement of the fifth wiring layer M5 including the metal wiring line 72 that supplies the power supply voltage VDD on the further upper side of the first wiring layer M1 to the fourth wiring layer M4 that form the first capacitive element EC including the wiring capacitance, the fifth wiring layer M5 configures a supply layer that supplies the power supply voltage to the first wiring layer M1 to the fourth wiring layer M4, and functions as a shield layer that prevents the first capacitive element EC from being affected by band noise from the outside of the circuit or the device above the fifth wiring layer M5.

As described above, since the first capacitive element EC is configured by the metal wiring lines 72 of the plurality of wiring layers M in the multilayer wiring layer 71, and the second capacitive element FC is configured by the polysilicon electrode 74 below the first wiring layer M1 and the N+ type semiconductor region 57 in the semiconductor substrate 51, the first capacitive element EC and the second capacitive element FC are arranged in different layers.

Note that, in a case where the first capacitive element EC is configured by the MOS capacitance and the second capacitive element FC is configured by the MIM capacitance, the second capacitive element FC, which is the MIM capacitance, is formed further above the first wiring layer M1 to the fifth wiring layer M5, and thus, also in this case, the first capacitive element EC and the second capacitive element FC are arranged in different layers. Even in a case where both the first capacitive element EC and the second capacitive element FC are configured by the MIM capacitance, the first capacitive element EC and the second capacitive element FC can be formed in mutually different layers.

### <6. First drive control example>

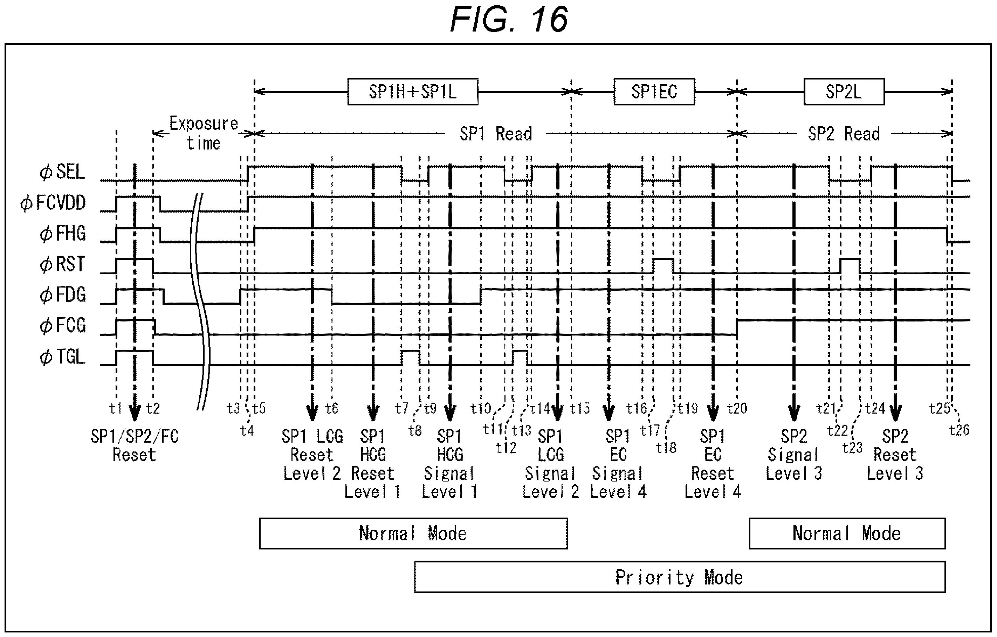

Next, the first drive control of the unit pixel 21 will be described with reference to a timing chart of Fig. 16. The first drive control in Fig. 16 is a drive that outputs four different signals in a single exposure.

First, at time t1, the voltage ϕFHG (hereinafter, also referred to as an EC supply voltage (pFHG) supplied to the electrode of the first capacitive element EC and the voltage ϕFCVDD(hereinafter, also referred to as the FC supply voltage ϕFCVDD) supplied to the electrode of the second capacitive element FC are set to the Hi level (for example, VDD), and the first transfer drive signal ϕTGL, the second transfer drive signal ϕFCG, the capacitance switching signal ϕFDG, and the reset drive signal ϕRST are controlled to the Hi level. As a result, all of the first FD unit 31, the second FD unit 32, the first capacitive element EC, and the second capacitive element FC are reset. After a predetermined time, the EC supply voltage ϕFHG and the FC supply voltage ϕFCVDD are controlled to the Lo level (for example, GND), and the first transfer drive signal ϕTGL, the second transfer drive signal ϕFCG, the capacitance switching signal ϕFDG, and the reset drive signal ϕRST are also controlled to the Lo level. An exposure period of the unit pixel 21 is started from time t2 when the first transfer transistor TGL and the reset transistor RST are turned off.

At time t3 after a predetermined exposure period has elapsed, the vertical drive unit 12 controls the capacitance switching signal ϕFDG to the Hi level, controls the FC supply voltage ϕFCVDD and the selection drive signal ϕSEL to the Hi level at time t4, and controls the EC supply voltage ϕFHG to the Hi level at time t5. After time t5, the accumulated charge readout period (SP1 HCG+LCG) of the first FD unit 31 and the second FD unit 32 of the first photoelectric converter SP1 comes.

First, in a period until the next time t6, a reset level (SP1 LCG Reset Level2) with low conversion efficiency using the first FD unit 31 and the second FD unit 32 is read, and at time t6, the capacitance switching signal ϕFDG supplied to the gate of the switching transistor FDG is controlled to the Lo level. Then, after the time t6, a reset level (SP1 HCG Reset Levell) of high conversion efficiency using only the first FD unit 31 is read.

Next, the vertical drive unit 12 controls the selection drive signal ϕSEL to the Lo level to turn off the selection transistor SEL in the period from time t7 to time t9, and controls the first transfer drive signal ϕTGL to the Hi level to turn on the first transfer transistor TGL in the period from time t7 to time t8, and transfers the charge generated by the first photoelectric converter SP1 to the first FD unit 31.

The vertical drive unit 12 controls the selection drive signal ϕSEL to the Hi level at time t9 to turn on the selection transistor SEL again. Then, in a period until the next time t10, a signal level (SP1 HCG Signal Levell) having high conversion efficiency using only the first FD unit 31 is read. The signal read here is a signal SP1H with ultra-low noise and high conversion efficiency.

At time t10, the vertical drive unit 12 controls the capacitance switching signal ϕFDG to the Hi level and turns on the switching transistor FDG.

Next, the vertical drive unit 12 controls the selection drive signal ϕSEL to the Lo level to turn off the selection transistor SEL in a period from time t11 to time t14, and controls the first transfer drive signal ϕTGL to the Hi level to turn on the first transfer drive signal ϕTGL in a period from time t12 to time t13, and transfers the charge generated by the first photoelectric converter SP1 to the first FD unit 31 and the second FD unit 32.

Thereafter, in a period from time t14 to time t15, a signal level (SP1 LCG Signal Level2) of low conversion efficiency using the first FD unit 31 and the second FD unit 32 is read. The signal read here is a signal SP1L having a different conversion efficiency (lower conversion efficiency than the signal SP1H) from the signal SP1H.

In the period from time t5 to time t15 described above, the read period (SP1 HCG+LCG) for reading the accumulated charges in the first FD unit 31 and the second FD unit 32 of the first photoelectric converter SP1 in the 1H period by CDS driving with each of the low conversion efficiency (SP1 LCG) and the high conversion efficiency (SP1 HCG) ends.

Next, after time t15, an accumulated charge readout period (SP1EC Read) of the first capacitive element EC of the first photoelectric converter SP1 starts.

First, in a period from time t15 to time t16, the signal level (SP1 EC Signal Level4) of the first capacitive element EC of the first photoelectric converter SP1 is read. The signal read here corresponds to the signal SP1EC accumulated in the first capacitive element EC of the large pixel.

Next, the vertical drive unit 12 controls the selection drive signal ϕSEL to the Lo level to turn off the selection transistor SEL in a period from time t16 to time t19, and controls the reset drive signal ϕRST to the Hi level to turn on the reset transistor RST in a period from time t17 to time t18, thereby resetting the accumulated charge. Thereafter, during a period from time t19 to the next time t20, an offset level (SP1 EC Reset Level4) using the first capacitive element EC is read.

In the period from time t15 to time t20 described above, the signal level of the first capacitive element EC of the first photoelectric converter SP1 is read, and then reset, and the read period (SP1 EC) of the DDS drive for reading the offset level ends.

Next, at time t20, the vertical drive unit 12 controls the second transfer drive signal ϕFCG to the Hi level to turn on the second transfer transistor FCG, and starts the readout period (SP2L) of the second photoelectric converter SP2.

First, in a period from time t20 to time t21, the signal level (SP2 Signal Level3) of the second capacitive element FC of the second photoelectric converter SP2 is read. The signal read here corresponds to the signal SP2L detected in the small pixel.

Next, the vertical drive unit 12 controls the selection drive signal ϕSEL to the Lo level to turn off the selection transistor SEL in a period from time t21 to time t24, and controls the reset drive signal ϕRST to the Hi level to turn on the reset transistor RST in a period from time t22 to time t23, thereby resetting the accumulated charge. Thereafter, during a period from time t24 to time t25, an offset level (SP2 Reset Level3) using the second capacitive element FC of the second photoelectric converter SP2 is read.

At time t26 after time t25, the selection drive signal ϕSEL is controlled to the Lo level, and the selection transistor SEL is turned off. As a result, the readout period (SP2L) of the DDS drive in which the signal level of the second capacitive element FC of the second photoelectric converter SP2 is read out and then reset and the offset level is read out ends.

A period from time t5 to time t20 is a read period (SP1 Read) of the first photoelectric converter SP1, and a period from time t20 to time t26 is a read period (SP2 Read) of the second photoelectric converter SP2.

As described above, the solid-state imaging device 1 can output four signals of the signal SP1H detected with high conversion efficiency (first conversion efficiency) in the large pixel, the signal SP1L detected with low conversion efficiency (second conversion efficiency) in the large pixel, the signal SP1EC corresponding to the accumulated charge of the first capacitive element EC of the large pixel, and the signal SP2L detected in the small pixel in the 1H period (one horizontal period) by the first drive control.

The solid-state imaging device 1 can output four different signals in the 1H period by using the first drive control. However, in order to achieve higher speed, the solid-state imaging device 1 can perform driving to output predetermined three signals among the four signals described above. At least one of the three signals to be output can be driven in a mode of a signal SP1EC corresponding to the accumulated charge of the first capacitive element EC of the large pixel.

Specifically, the solid-state imaging device 1 can perform, as the second drive control, driving to output three signals, which are a signal SP1H detected with high conversion efficiency in the large pixel, a signal SP1L detected with low conversion efficiency in the large pixel, and a signal SP2L detected in the small pixel, and are described as the normal mode in Fig. 16.

Furthermore, the solid-state imaging device 1 can perform, as the third drive control, driving to output three signals, which are a signal SP1L detected with low conversion efficiency in the large pixel, a signal SP1EC corresponding to the accumulated charge of the first capacitive element EC in the large pixel, and a signal SP2L detected in the small pixel, and are described as the priority mode in Fig. 16.

### <7. Second drive control example (normal mode)>

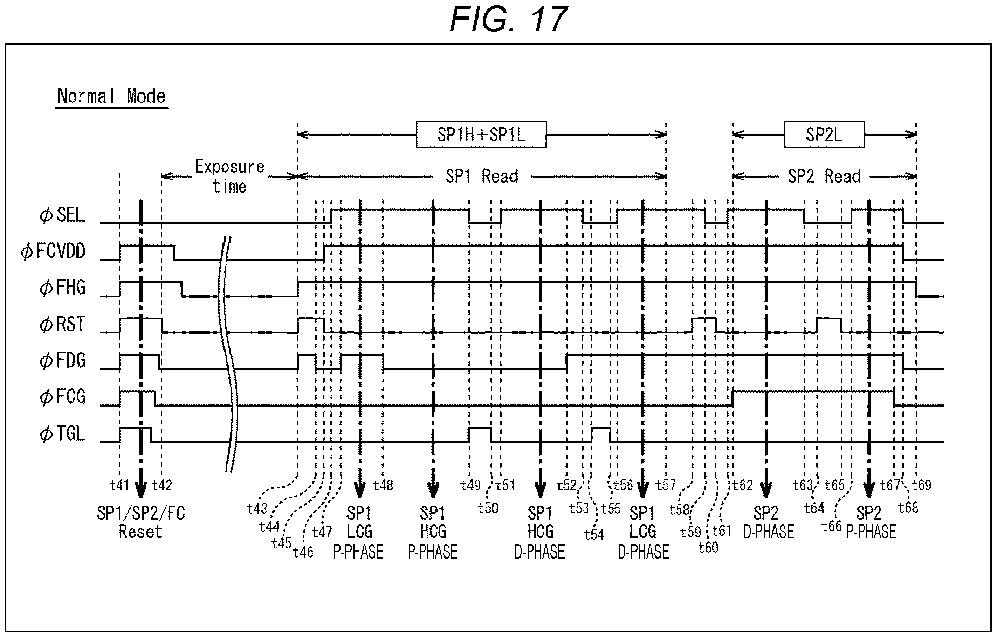

Fig. 17 is a time chart for describing the drive in the normal mode as the second drive control. This normal mode is a mode strong against low illuminance, in which signals of the first photoelectric converter SP1 of the large pixel are read out with different conversion efficiency.

First, at time t41, the EC supply voltage ϕFHG and the FC supply voltage ϕFCVDD are set to the Hi level (for example, VDD), and the first transfer drive signal ϕTGL, the second transfer drive signal ϕFCG, the capacitance switching signal ϕFDG, and the reset drive signal ϕRST are controlled to the Hi level. As a result, all of the first FD unit 31, the second FD unit 32, the first capacitive element EC, and the second capacitive element FC are reset. After a predetermined time, the EC supply voltage ϕFHG and the FC supply voltage ϕFCVDD are controlled to the Lo level (for example, GND), and the first transfer drive signal ϕTGL, the second transfer drive signal ϕFCG, the capacitance switching signal ϕFDG, and the reset drive signal ϕRST are also controlled to the Lo level. The exposure period of the unit pixel 21 is started from time t42 when the reset transistor RST is turned off.

At time t43 after a predetermined exposure period has elapsed, the vertical drive unit 12 controls the EC supply voltage ϕFHG and the reset drive signal ϕRST to the Hi level, turns on the second transfer transistor FCG and the reset transistor RST, and resets the first FD unit 31 and the second FD unit 32. After time t43, the accumulated charge readout period (SP1 HCG+LCG) of the first FD unit 31 and the second FD unit 32 of the first photoelectric converter SP1 comes.

At time t44, the capacitance switching signal ϕFDG supplied to the gate of the switching transistor FDG is controlled to the Lo level, and then, at time t45, the reset drive signal ϕRST is controlled to the Lo level, the reset transistor RST is turned off, and the FC supply voltage ϕFCVDD is set to the Hi level.

Next, the vertical drive unit 12 controls the selection drive signal ϕSEL to the Hi level and turns on the selection transistor SEL in a period from time t46 to time t49. The vertical drive unit 12 turns on the switching transistor FDG by controlling the capacitance switching signal ϕFDG to the Hi level in a period from time t47 to time t48 in a period in which the selection transistor SEL is turned on, and reads the reset level (SP1 LCG Reset Level2) with low conversion efficiency using the first FD unit 31 and the second FD unit 32. Thereafter, in a period from time t48 to time t49, the vertical drive unit 12 controls the capacitance switching signal ϕFDG to the Lo level to turn off the switching transistor FDG, and reads the reset level (SP1 HCG Reset Levell) of the high conversion efficiency using only the first FD unit 31.

Next, at time t49, the vertical drive unit 12 controls the selection drive signal ϕSEL to the Lo level to turn off the selection transistor SEL, and controls the first transfer drive signal ϕTGL to the Hi level to turn on the first transfer transistor TGL in a period from time t49 to time t50, and transfers the charge generated by the first photoelectric converter SP1 to the first FD unit 31.

At time t51, the vertical drive unit 12 controls the selection drive signal ϕSEL to the Hi level and turns on the selection transistor SEL again. Then, in a period until the next time t52, a signal level (SP1 HCG Signal Levell) having high conversion efficiency using only the first FD unit 31 is read.

The signal read here is a signal SP1H with ultra-low noise and high conversion efficiency.

At time t52, the vertical drive unit 12 controls the capacitance switching signal ϕFDG to the Hi level and turns on the switching transistor FDG.

Next, the vertical drive unit 12 controls the selection drive signal ϕSEL to the Lo level to turn off the selection transistor SEL in a period from time t53 to time t56, and controls the first transfer drive signal ϕTGL to the Hi level to turn on the first transfer transistor TGL in a period from time t54 to time t55, and transfers the charge generated by the first photoelectric converter SP1 to the first FD unit 31 and the second FD unit 32.

Thereafter, in a period from time t56 to time t57, a signal level (SP1 LCG Signal Level2) of low conversion efficiency using the first FD unit 31 and the second FD unit 32 is read. The signal read here is a signal SP1L having a different conversion efficiency (lower conversion efficiency than the signal SP1H) from the signal SP1H.

In the period from time t43 to time t57 described above, the read period (SP1 HCG+LCG) for reading the accumulated charges in the first FD unit 31 and the second FD unit 32 of the first photoelectric converter SP1 in the 1H period by the CDS driving with each of the low conversion efficiency (SP1 LCG) and the high conversion efficiency (SP1 HCG) ends.

Next, the vertical drive unit 12 controls the reset drive signal ϕRST to the Hi level at time t58 to turn on the reset transistor RST, and controls the selection drive signal ϕSEL to the Lo level at time t59 to turn off the selection transistor SEL. Thereafter, the vertical drive unit 12 controls the reset drive signal ϕRST to the Lo level at time t60 to turn off the reset transistor RST.

Next, the vertical drive unit 12 controls the selection drive signal ϕSEL to the Hi level at time t61 to turn on the selection transistor SEL. From time t62 after time t61, the readout period (SP2L) of the second photoelectric converter SP2 starts.

At time t62, the vertical drive unit 12 controls the second transfer drive signal ϕFCG to the Hi level to turn on the second transfer transistor FCG. Then, in a period until the next time t63, the signal level (SP2 Signal Level3) of the second capacitive element FC of the second photoelectric converter SP2 is read. The signal read here is the signal SP2L detected in the small pixel.

Next, the vertical drive unit 12 controls the selection drive signal ϕSEL to the Lo level to turn off the selection transistor SEL in a period from time t63 to time t66, and controls the reset drive signal ϕRST to the Hi level to turn on the reset transistor RST in a period from time t64 to time t65, thereby resetting the accumulated charge. Thereafter, during a period from time t66 to time t67, an offset level (SP2 Reset Level3) using the second capacitive element FC of the second photoelectric converter SP2 is read.

At time t67, the second transfer drive signal ϕFCG is controlled to the Lo level, and the second transfer transistor FCG is turned off. At a time t68 after the time t67, the FC supply voltage ϕFCVDD is controlled to the Lo level, the selection drive signal ϕSEL and the capacitance switching signal ϕFDG are controlled to the Lo level, and the selection transistor SEL and the switching transistor FDG are turned off. As a result, the readout period (SP2L) of the DDS drive in which the signal level of the second capacitive element FC of the second photoelectric converter SP2 is read out and then reset and the offset level is read out ends.

A period from time t43 to time t57 is a read period (SP1 Read) of the first photoelectric converter SP1, and a period from time t61 to time t69 is a read period (SP2 Read) of the second photoelectric converter SP2.

As described above, the solid-state imaging device 1 can perform, as the normal mode (second drive control), drive to output three signals of the signal SP1H detected with high conversion efficiency (first conversion efficiency) in the large pixel, the signal SP1L detected with low conversion efficiency (second conversion efficiency) in the large pixel, and the signal SP2L detected in the small pixel in a 1H period (one horizontal period).

### <8. Third drive control example (priority mode)>

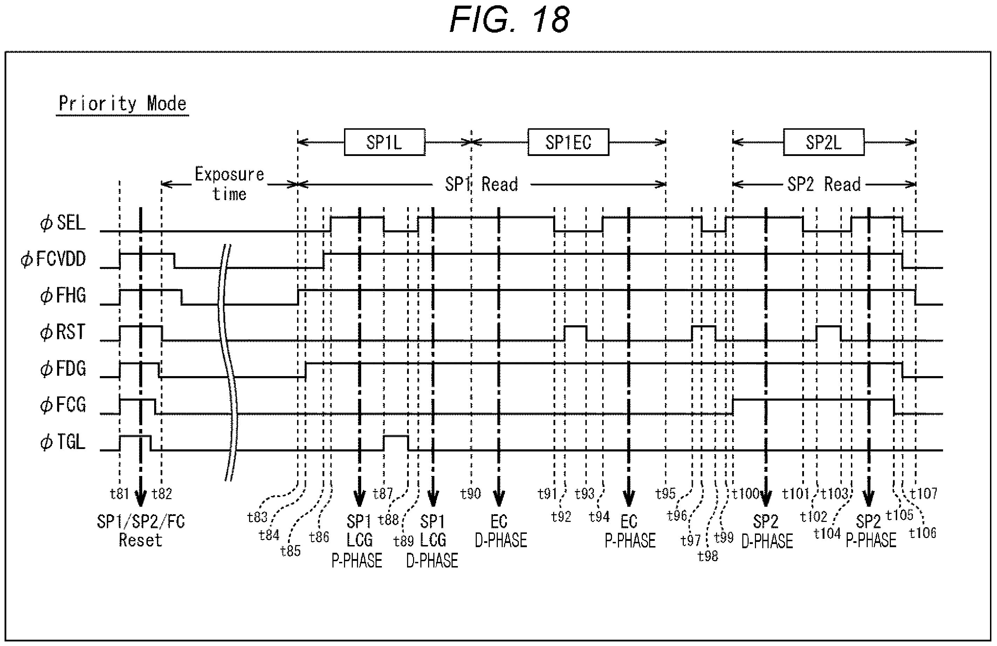

Fig. 18 is a time chart illustrating driving in the priority mode as the third drive control. This priority mode is a mode in which a decrease in the SN ratio is reduced and high illuminance is emphasized.

First, at time t81, the EC supply voltage ϕFHG and the FC supply voltage ϕFCVDD are set to the Hi level (for example, VDD), and the first transfer drive signal ϕTGL, the second transfer drive signal ϕFCG, the capacitance switching signal ϕFDG, and the reset drive signal ϕRST are controlled to the Hi level. As a result, all of the first FD unit 31, the second FD unit 32, the first capacitive element EC, and the second capacitive element FC are reset. After a predetermined time, the EC supply voltage ϕFHG and the FC supply voltage ϕFCVDD are controlled to the Lo level (for example, GND), and the first transfer drive signal ϕTGL, the second transfer drive signal ϕFCG, the capacitance switching signal ϕFDG, and the reset drive signal ϕRST are also controlled to the Lo level. The exposure period of the unit pixel 21 is started from time t82 when the reset transistor RST is turned off.

At time t83 after a predetermined exposure period has elapsed, the vertical drive unit 12 controls the EC supply voltage ϕFHG to the Hi level. After time t83, the accumulated charge readout period (SP1 LCG) due to the low conversion efficiency of the first photoelectric converter SP1 starts.

First, the vertical drive unit 12 controls the capacitance switching signal ϕFDG supplied to the gate of the switching transistor FDG to the Hi level at time t84, and controls the FC supply voltage ϕFCVDD to the Hi level at time t85.

Next, the vertical drive unit 12 controls the selection drive signal ϕSEL to the Hi level and turns on the selection transistor SEL in a period from time t86 to time t87. During a period from time t86 to time t87, a reset level (SP1 LCG Reset Level2) of low conversion efficiency using the first FD unit 31 and the second FD unit 32 is read.

Furthermore, the vertical drive unit 12 controls the selection drive signal ϕSEL to the Lo level to turn off the selection transistor SEL in a period from time t87 to time t89, and controls the first transfer drive signal ϕTGL to the Hi level to turn on the first transfer transistor TGL in a period from time t87 to time t88, and transfers the charge generated by the first photoelectric converter SP1 to the first FD unit 31 and the second FD unit 32.

Next, the vertical drive unit 12 controls the selection drive signal ϕSEL to the Hi level and turns on the selection transistor SEL in a period from time t89 to time t91. During a period from time t89 to time t90, the signal levels (SP1 LCG Signal Level2) accumulated in the first FD unit 31 and the second FD unit 32 are read. The signal read here is a signal SP1L having a different conversion efficiency (lower conversion efficiency than the signal SP1H) from the signal SP1H. Subsequently, during a period from time t90 to time t91, the signal level (SP1 EC Signal Level4) of the first capacitive element EC of the first photoelectric converter SP1 is read out. The signal read here is the signal SP1EC accumulated in the first capacitive element EC of the large pixel.

Next, the vertical drive unit 12 controls the selection drive signal ϕSEL to the Lo level to turn off the selection transistor SEL in a period from time t91 to time t94, and controls the reset drive signal ϕRST to the Hi level to turn on the reset transistor RST in a period from time t92 to time t93, thereby resetting the accumulated charge. Thereafter, during a period from time t94 to the next time t95, an offset level (SP1 EC Reset Level4) using the first capacitive element EC is read. As a result, the readout period (SP1 EC) of the DDS drive in which the signal level of the first capacitive element EC of the first photoelectric converter SP1 is read out, then reset is performed, and the offset level is read out is ended.

At time t96 after time t95, the vertical drive unit 12 controls the reset drive signal ϕRST to the Hi level to turn on the reset transistor RST, and controls the selection drive signal ϕSEL to the Lo level to turn off the selection transistor SEL at time t97. Thereafter, the vertical drive unit 12 controls the reset drive signal ϕRST to the Lo level at time t98 to turn off the reset transistor RST.

Next, the vertical drive unit 12 controls the selection drive signal ϕSEL to the Hi level at time t99 to turn on the selection transistor SEL. From time t100 after time t99, the readout period (SP2L) of the second photoelectric converter SP2 starts.

At time t100, the vertical drive unit 12 controls the second transfer drive signal ϕFCG to the Hi level to turn on the second transfer transistor FCG. Thereafter, in a period until the next time t101, the signal level (SP2 Signal Level3) of the second capacitive element FC of the second photoelectric converter SP2 is read. The signal read here is the signal SP2L detected in the small pixel.

Next, the vertical drive unit 12 controls the selection drive signal ϕSEL to the Lo level to turn off the selection transistor SEL in a period from time t101 to time t104, and controls the reset drive signal ϕRST to the Hi level to turn on the reset transistor RST in a period from time t102 to time t103, thereby resetting the accumulated charge. Thereafter, during a period from time t104 to time t105, an offset level (SP2 Reset Level3) using the second capacitive element FC of the second photoelectric converter SP2 is read.

At time t105, the second transfer drive signal ϕFCG is controlled to the Lo level, and the second transfer transistor FCG is turned off. At a time t106 after the time t105, the FC supply voltage ϕFCVDD is controlled to the Lo level, the selection drive signal ϕSEL and the capacitance switching signal ϕFDG are controlled to the Lo level, and the selection transistor SEL and the switching transistor FDG are turned off.

At time t107, the EC supply voltage ϕFHG is controlled to the Lo level. As a result, the readout period (SP2L) of the DDS drive in which the signal level of the second capacitive element FC of the second photoelectric converter SP2 is read out and then reset and the offset level is read out ends.

The period from time t83 to time t95 described above is the read period (SP1 Read) of the first photoelectric converter SP1, and the period from time t100 to time t107 is the read period (SP2 Read) of the second photoelectric converter SP2.

As described above, as the priority mode (third drive control), the solid-state imaging device 1 can perform drive to output three signals of the signal SP1L detected with low conversion efficiency in the large pixel, the signal SP1EC corresponding to the accumulated charge of the first capacitive element EC in the large pixel, and the signal SP2L detected in the small pixel.

### <9. Characteristics of normal mode and priority mode>

Characteristics of the normal mode and the priority mode will be described.

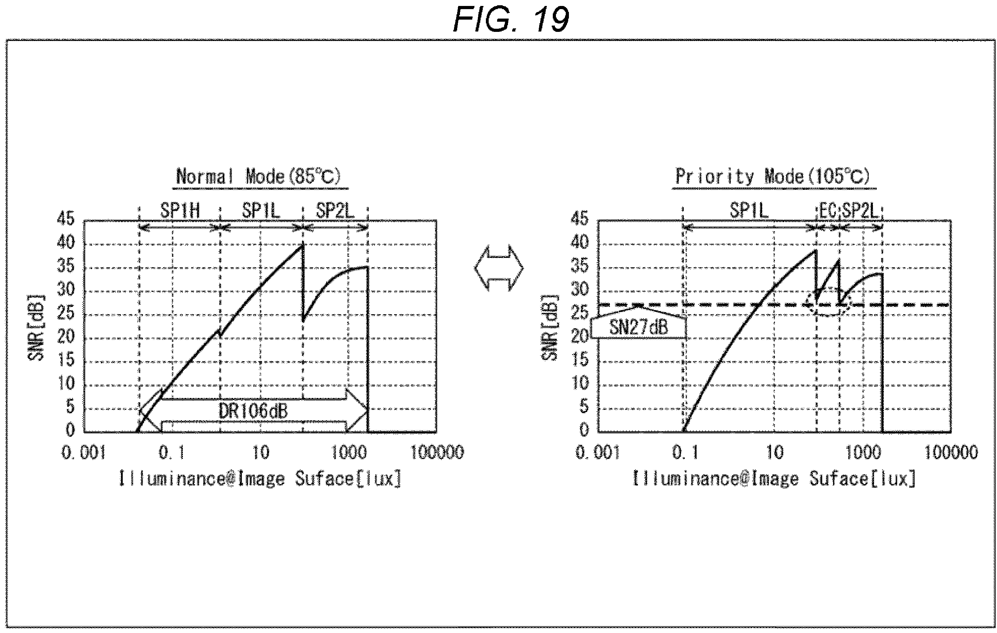

Fig. 19 is a graph illustrating photoelectric conversion characteristics of the normal mode and the priority mode. The horizontal axis of the photoelectric conversion characteristic graph represents illuminance (light reception amount) on the light receiving surface of the solid-state imaging device 1, and the vertical axis represents an SN ratio.

A graph on the left side of Fig. 19 illustrates a photoelectric conversion characteristic graph in the normal mode in a case where the sensor value of the temperature sensor provided in the solid-state imaging device 1 is 85°C. A graph on the right side of Fig. 19 illustrates a photoelectric conversion characteristic graph in a priority mode in a case where the sensor value of the temperature sensor provided in the solid-state imaging device 1 is 105°C.

In the normal mode, the solid-state imaging device 1 acquires three signals of a signal SP1H detected with high conversion efficiency in a large pixel, a signal SP1L detected with low conversion efficiency in a large pixel, and a signal SP2L detected in a small pixel. The normal mode is a mode in which the signal SP1 of the large pixel is read with different conversion efficiencies of high conversion efficiency (first conversion efficiency) and low conversion efficiency (second conversion efficiency). In the normal mode, a high dynamic range of 106 dB is realized by acquiring the signal SP1H having ultra-low noise and high conversion efficiency. However, in the normal mode, the SN ratio decreases in the illuminance for switching between the signal SP1L and the signal SP2L.

On the other hand, in the priority mode, three signals of the signal SP1L detected with low conversion efficiency in the large pixel, the signal SP1EC accumulated in the first capacitive element EC of the large pixel, and the signal SP2L detected in the small pixel are acquired. The priority mode is a mode for reading the signal SP1EC accumulated in the first capacitive element EC of the large pixel. In the priority mode, by using the first capacitive element EC of the large pixel, it is possible to reduce a decrease in the SN ratio at the time of switching between the signal SP1L and the signal SP1EC and at the time of switching between the signal SP1EC and the signal SP2L, and to raise the SN ratio to about 27 dB.

As described above, the normal mode is a mode in which priority is given to dynamic range expansion and which is strong against low illuminance, and the priority mode is a mode in which priority is given to an SN ratio and emphasis is placed on low noise and high illuminance. Alternatively, furthermore, since the low illuminance sensitivity is switched to the signal SP1H with high conversion efficiency in the normal mode and the signal SP1L with low conversion efficiency in the priority mode, it can be said that the normal mode and the priority mode are two modes that output the low illuminance sensitivity with different sensitivities.

For example, the solid-state imaging device 1 can be driven by switching between a normal mode strong against low illuminance and a priority mode focusing on high illuminance according to the illuminance. Specifically, the operation can be switched such that the driving is performed in the normal mode in the dark (low illuminance) and the driving is performed in the priority mode in the bright (high illuminance).

In a case where the solid-state imaging device 1 is mounted on a vehicle such as an automobile as an imaging sensor, the following mode switching operation is possible.
· The normal mode and the priority mode can be switched and driven by determining that "ON" = "Dark" and "OFF" = "BRIGHT" according to on/off of the illumination power supply in conjunction with on/off operation of turning on/off the light of the vehicle.
· A clock built in the vehicle can be used to determine a time zone of morning/daytime/evening/night, and can be driven by switching between the normal mode and the priority mode. In addition, for example, it is possible to set the daytime/nighttime switching time on the basis of sunrise/sunset time information stored therein from the own vehicle position (latitude and longitude), the time of a clock built in the vehicle, and the time (month), and to switch between the normal mode and the priority mode for driving.
· Whether the external environment is dark or bright can be determined from the output of the illuminance sensor mounted on the vehicle, and the normal mode and the priority mode can be switched and driven.
· It is possible to determine whether or not the vehicle is in a tunnel on the basis of an output of a positioning sensor that receives a signal from a global navigation satellite system (GNSS) such as a global positioning system (GPS), and perform control to drive in a normal mode when the vehicle position is in the tunnel.

According to the solid-state imaging device 1, switching between the normal mode and the priority mode as necessary to acquire a signal enables high-speed driving. For example, driving at 40 fps becomes possible.

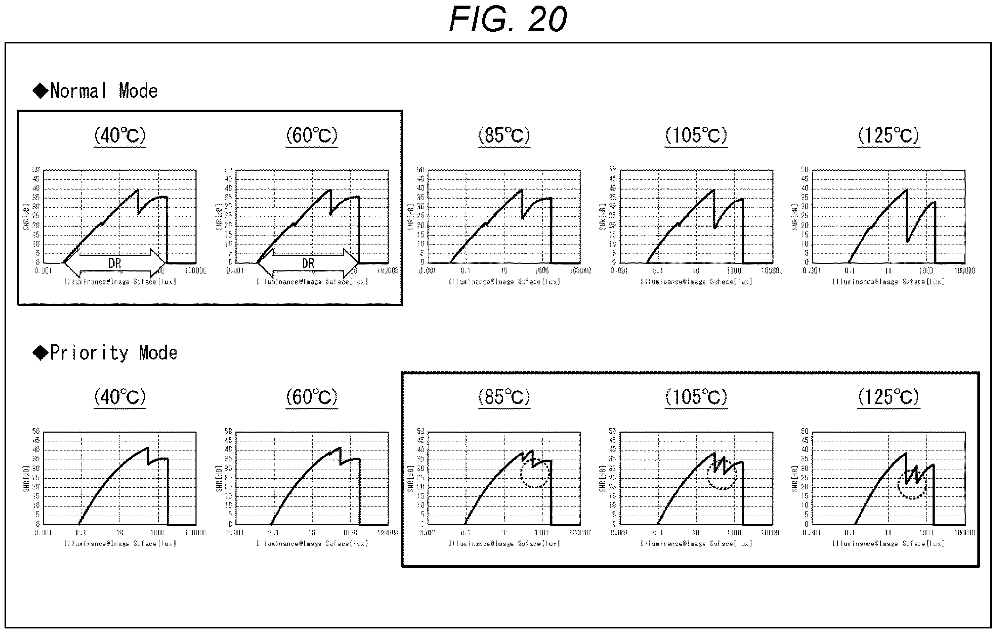

Fig. 20 illustrates a result of measuring the photoelectric conversion characteristic in each of the normal mode and the priority mode under a plurality of temperature conditions.

Fig. 20 illustrates photoelectric conversion characteristics in a case where the sensor value of the temperature sensor in the solid-state imaging device 1 is 40°C, 60°C, 85°C, 105°C, and 125°C.

In the normal mode, under an environment where the sensor temperature is low at 40°C or 60°C, the decrease in the SN ratio at the time of switching from the signal SP1L to the signal SP2L is not large, and detection can be performed in a wide dynamic range. However, as the sensor temperature increases, the decrease in the SN ratio at the time of switching from the signal SP1L to the signal SP2L increases.

On the other hand, in the priority mode, as indicated by dashed circles, even in an environment where the sensor temperature is as high as 85°C, 105°C, or 125°C, it is possible to detect the SN ratio while suppressing a decrease in the SN ratio.

For example, the system control section 15 of the solid-state imaging device 1 can switch the driving in conjunction with the temperature so as to perform the driving in the normal mode under a temperature condition where the sensor temperature is lower than 85°C and perform the driving in the priority mode under a high temperature condition where the sensor temperature is 85°C or higher.

### <10. Effect of comb-teeth shaped wiring capacitance>

As described above, the first capacitive element EC includes the wiring capacitance in the multilayer wiring layer 71, and the second capacitive element FC includes the MOS capacitance. An effect of forming the metal wiring line 72 configuring the wiring capacitance of the first capacitive element EC in a comb-tooth shape will be described.

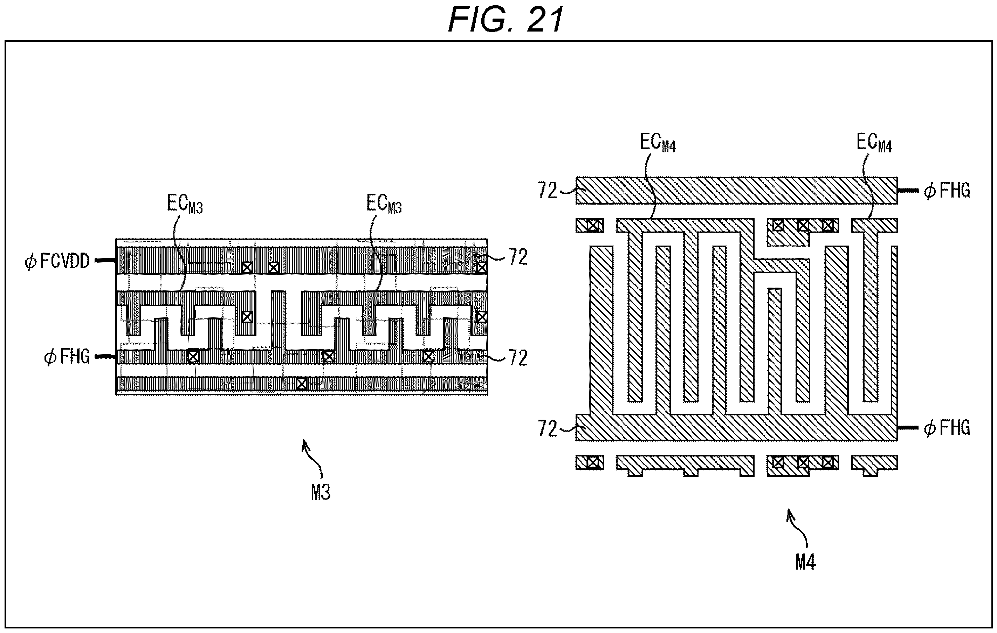

Fig. 21 illustrates an enlarged view of the metal wiring line EC_{M3} of the third wiring layer M3 and the metal wiring line EC_{M4} of the fourth wiring layer M4 which are part of the first capacitive elements EC formed in the first wiring layer M1 to the fourth wiring layer M4 in Figs. 11 to 14 and formed in a comb tooth shape.

As illustrated in the plan view on the left side of Fig. 21, the metal wiring line EC_{M3} of the third wiring layer M3 is formed in a comb tooth shape, and the metal wiring line 72 for supplying the FC supply voltage ϕFCVDD and the metal wiring line 72 for supplying the EC supply voltage ϕFHG are arranged adjacently on both sides (upper and lower sides) of the metal wiring line EC_{M3}.

As illustrated in the plan view on the right side of Fig. 21, the metal wiring line EC_{M4} of the fourth wiring layer M4 is also formed in a comb tooth shape, and the metal wiring lines 72 for supplying the EC supply voltage ϕFHG are arranged adjacently on both sides (upper and lower sides) of the metal wiring line EC_{M4}.

In this manner, not a single voltage supply line but a plurality of voltage supply lines is arranged on both sides of the metal wiring lines EC_{M3} and EC_{M4} formed in the comb teeth shape and coupled to the plurality of voltage supply lines, whereby the voltages of the first FD unit 31 and the second FD unit 32 at the time of reading can be boosted and the saturation charge amount of the first capacitive element EC can be increased.

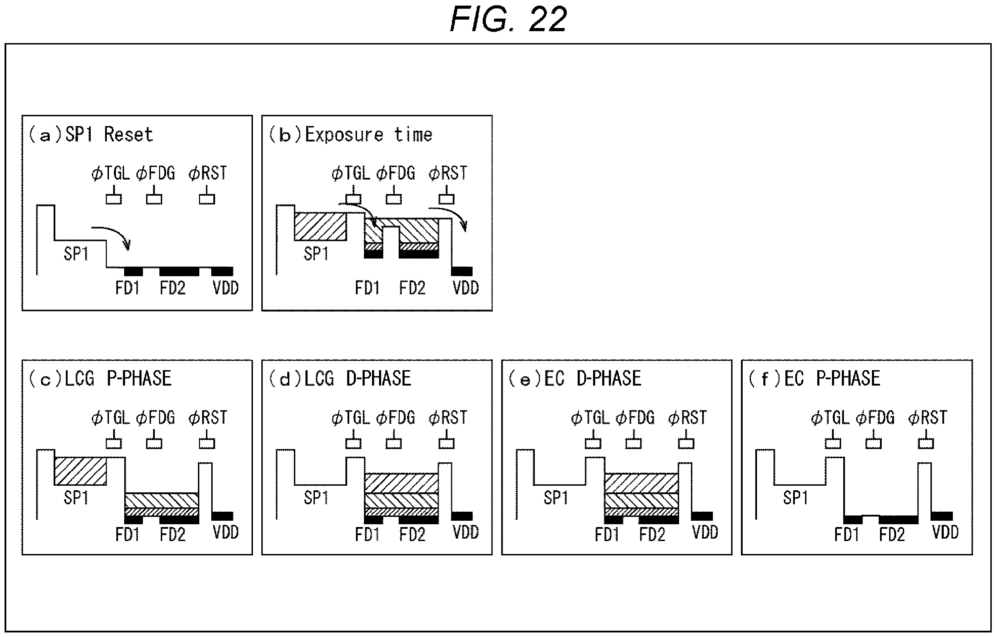

Fig. 22 illustrates a potential diagram of a large pixel at the time of priority mode drive.

As described with reference to the time chart of Fig. 18, in the priority mode, (a) the first FD unit 31, the second FD unit 32, and the first capacitive element EC are reset, and then (b) the exposure period is started. Thereafter, (c) the reset level (SP1 LCG Reset Level2) having low conversion efficiency, which is the P-phase having low illuminance sensitivity, and (d) the signal level (SP1 LCG Signal Level2) having low conversion efficiency, which is the D-phase having low illuminance sensitivity, are read out. Next, (e) the signal level (SP1 EC Signal Level4) of the first capacitive element EC, which is the D-phase with medium illuminance sensitivity, and (f) the offset level (SP1 EC Reset Level4) of the first capacitive element EC, which is the P-phase with medium illuminance sensitivity, are read.

As described with reference to the timing chart of Fig. 18, the EC supply voltage ϕFHG and the FC supply voltage ϕFCVDD are controlled to the Hi level at the time of reading the signal level or the offset level of (c) to (f). At this time, the voltage supply wiring of the EC supply voltage ϕFHG and the FC supply voltage ϕFCVDD and the comb-teeth shaped metal wiring line EC_{M3} and EC_{M4} are coupled to each other, so that the voltages of the first FD unit 31 and the second FD unit 32 increase. In the potential diagram of Fig. 22, the potentials of the first FD unit 31 and the second FD unit 32 at the time of reading of (c) to (f) are deeper than those during the exposure period of (b).

In the driving using the first capacitive element EC, since the charge of the first photoelectric converter SP1 is added at the time of reading in addition to the capacitance during the exposure period, the capacitance value at the time of reading is also an important element. The saturation charge amount of the first capacitive element EC can be further expanded by forming the metal wiring lines EC_{M3} and EC_{M4} in a comb tooth shape and coupling the metal wiring lines EC_{M3} and EC_{M4} to a plurality of voltage supply wires.

### <11. Second circuit configuration example of unit pixel>

Next, another circuit configuration of the unit pixel 21 will be described.

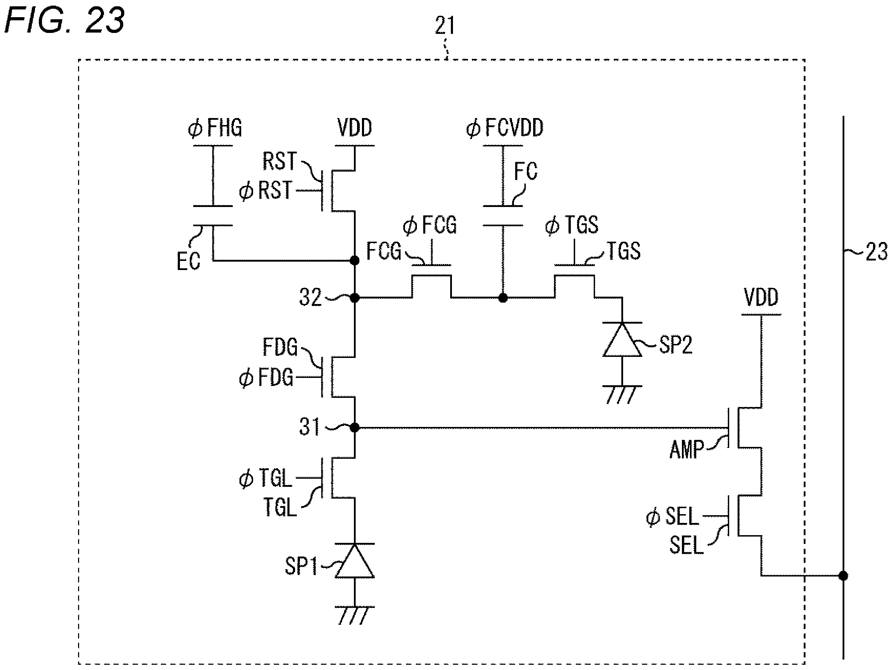

Fig. 23 is a diagram illustrating a second circuit configuration example of the unit pixel 21. In Fig. 23, portions common to those of the first circuit configuration example illustrated in Fig. 2 are denoted by the same reference numerals, and description of the portions will be omitted as appropriate.

The unit pixel 21 in Fig. 23 is different from the first circuit configuration example illustrated in Fig. 2 in that a third transfer transistor TGS is newly added between the cathode terminal of the photodiode which is the second photoelectric converter SP2, and the second capacitive element FC and the second transfer transistor FCG. The other points are similar to those of the first circuit configuration example illustrated in Fig. 2.

When turned on by the third transfer drive signal ϕTGS supplied to the gate electrode, the third transfer transistor TGS reads the charge generated by the second photoelectric converter SP2 and transfers the charge to the second capacitive element FC.

### <Arrangement example of pixel transistor>

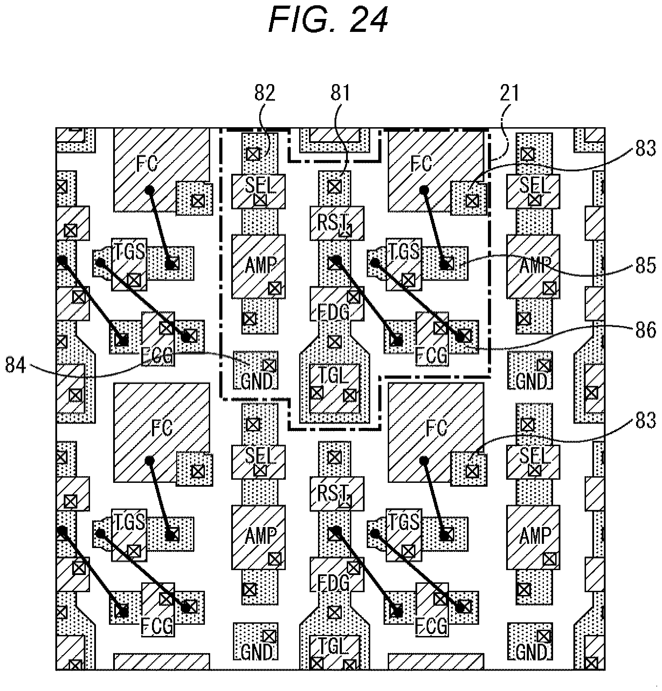

Fig. 24 is a plan view illustrating a pixel transistor arrangement example of the second circuit configuration example of the unit pixel 21. Fig. 24 corresponds to a plan view illustrating the pixel transistor arrangement of the first circuit configuration example illustrated in B of Fig. 3. Also in Fig. 24, portions corresponding to those in the first circuit configuration example illustrated in B of Fig. 3 are denoted by the same reference numerals, and description of those portions will be omitted as appropriate.

In the first circuit configuration example in B of Fig. 3, the first transfer transistor TGL, the switching transistor FDG, the reset transistor RST, and the second transfer transistor FCG arranged in the vertical direction are formed in the first active region 81. On the other hand, in the second circuit configuration example of Fig. 24, only the first transfer transistor TGL, the switching transistor FDG, and the reset transistor RST are formed in the first active region 81.

In the region where the second transfer transistor FCG is formed in the first circuit configuration example, the fifth active region 85 where the third transfer transistor TGS is formed is arranged. On the upper side of the fifth active region 85 where the third transfer transistor TGS is formed, the third active region 83 where one electrode (N+ type semiconductor region 57 in Fig. 4) of the second capacitive element FC is formed is arranged. The sixth active region 86 in which the second transfer transistor FCG is formed is arranged below the fifth active region 85 on the opposite side of the third active region 83. The third transfer transistor TGS is connected to the electrode of the second capacitive element FC formed in the upper third active region 83 and the third transfer transistor TGS formed in the lower sixth active region 86.

The second active region 82 and the fourth active region 84 are formed similarly to the first circuit configuration example.

### <12. Drive control example of second circuit configuration example>

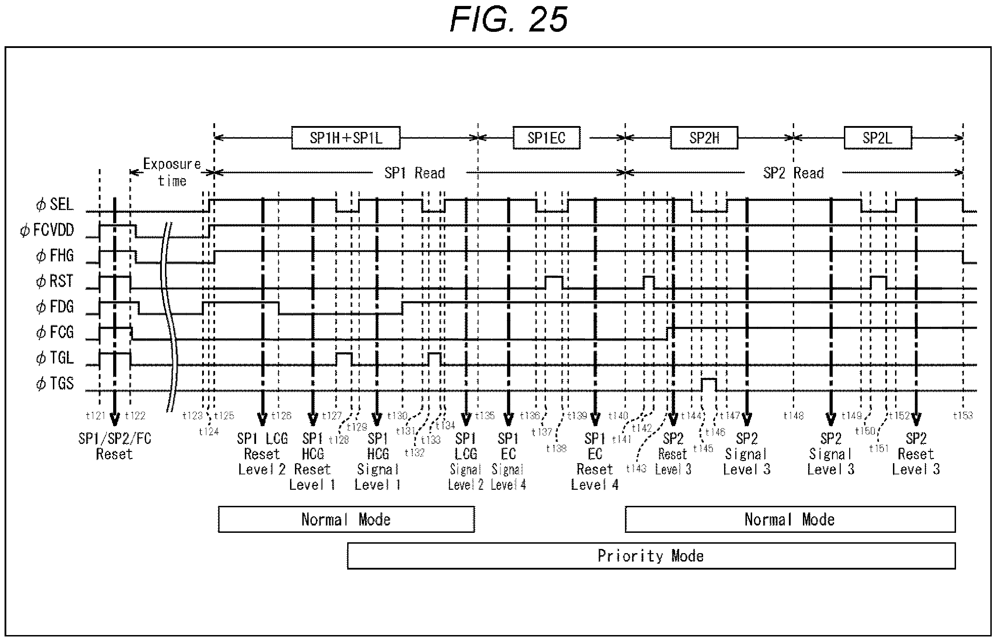

Next, a drive control of the second circuit configuration example of the unit pixel 21 will be described with reference to a timing chart of Fig. 25. This drive control is referred to as fourth drive control. The fourth drive control is a drive that outputs five different signals in a single exposure.

Since the second circuit configuration example is different from the first circuit configuration example in the presence or absence of the third transfer transistor TGS related to the reading of the small pixel (the second photoelectric converter SP2), the reading (SP1 Read) of the large pixel is similar to the first drive control of the first circuit configuration example. Specifically, the driving from time t121 to immediately before time t140 is the same as the driving from time t1 to immediately before time t20 of the first drive control in Fig. 16. Therefore, the description of the driving from the time t121 to immediately before the time t140 will be omitted. In the first drive control of Fig. 16, the second transfer drive signal ϕFCG is controlled to the Hi level and the second transfer transistor FCG is turned on at time t20 when the reading (SP1 Read) of the large pixel ends, but in the fourth drive control of Fig. 25, the second transfer drive signal ϕFCG is maintained at the Lo level at time t140.

During a period from time t141 to time t142, the vertical drive unit 12 controls the reset drive signal ϕRST to a Hi level, turns on the reset transistor RST, and resets the accumulated charge. Thereafter, at time t143, the vertical drive unit 12 controls the second transfer drive signal ϕFCG to the Hi level to turn on the second transfer transistor FCG. Thereafter, in a period from time t143 to time t144, the offset level (SP2 Reset Level3) of the second capacitive element FC of the second photoelectric converter SP2 is read.

Next, the vertical drive unit 12 controls the selection drive signal ϕSEL to the Lo level to turn off the selection transistor SEL in a period from time t144 to time t147, and controls the third transfer drive signal ϕTGS to the Hi level to turn on the third transfer transistor TGS in a period from time t145 to time t146, and transfers the accumulated charge of the second photoelectric converter SP2 to the second capacitive element FC.

In a period from the next time t147 to time t148, the signal level (SP2 Signal Level3) of the second capacitive element FC of the second photoelectric converter SP2 is read. The signal read here is a signal SP2H corresponding to the accumulated charge of only the second photoelectric converter SP2 of the small pixel. As a result, the readout period (SP2H) of the DDS drive in which the signal level corresponding to the accumulated charge of only the second photoelectric converter SP2 is read out and then reset and the offset level is read out ends.

During a period from the next time t148 to time t149, the vertical drive unit 12 reads the signal level (SP2 Signal Level3) of the second capacitive element FC of the second photoelectric converter SP2. The signal read here corresponds to the signal SP2L corresponding to the accumulated charge including the second capacitive element FC of the small pixel.

Next, the vertical drive unit 12 controls the selection drive signal ϕSEL to the Lo level to turn off the selection transistor SEL in a period from time t149 to time t152, and controls the reset drive signal ϕRST to the Hi level to turn on the reset transistor RST in a period from time t150 to time t151, thereby resetting the accumulated charge. Thereafter, during a period from time t152 to time t153, an offset level (SP2 Reset Level3) using the second capacitive element FC of the second photoelectric converter SP2 is read. As a result, the readout period (SP2L) of the DDS drive in which the signal level corresponding to the accumulated charge including the second capacitive element FC of the small pixel is read out, then reset is performed, and the offset level is read out is ended.

At time t153 after time t152, the selection drive signal ϕSEL is controlled to the Lo level, and the selection transistor SEL is turned off.

A period from time t125 to time t140 is a read period (SP1 Read) of the first photoelectric converter SP1, and a period from time t140 to time t153 is a read period (SP2 Read) of the second photoelectric converter SP2.

As described above, the solid-state imaging device 1 can output five signals of the signal SP1H detected with high conversion efficiency (first conversion efficiency) in the large pixel, the signal SP1L detected with low conversion efficiency (second conversion efficiency) in the large pixel, the signal SP1EC corresponding to the accumulated charge of the first capacitive element EC of the large pixel, the signal SP2H corresponding to the accumulated charge of only the second photoelectric converter SP2 of the small pixel, and the signal SP2L corresponding to the accumulated charge including the second capacitive element FC of the small pixel in the 1H period (one horizontal period) by the fourth drive control.

According to the fourth drive control, the solid-state imaging device 1 can output five different signals in the 1H period. However, in order to achieve higher speed, the solid-state imaging device 1 can perform drive to output predetermined four signals among the five signals described above.

Specifically, the solid-state imaging device 1 can perform, as the fifth drive control, drive described as the normal mode in Fig. 25, to output four signals of a signal SP1H detected with high conversion efficiency in the large pixel, a signal SP1L detected with low conversion efficiency in the large pixel, a signal SP2H corresponding to the accumulated charge of only the second photoelectric converter SP2 of the small pixel, and a signal SP2L corresponding to the accumulated charge including the second capacitive element FC of the small pixel.

Furthermore, the solid-state imaging device 1 can perform, as the sixth drive control, driving to output four signals, which are described as a priority mode in Fig. 25, the signal SP1L detected with low conversion efficiency in the large pixel, the signal SP1EC corresponding to the accumulated charge of the first capacitive element EC of the large pixel, the signal SP2H corresponding to the accumulated charge of only the second photoelectric converter SP2 of the small pixel, and the signal SP2L corresponding to the accumulated charge including the second capacitive element FC of the small pixel. Illustration of individual time charts of the normal mode and the priority mode will be omitted.

### <13. Third circuit configuration example of unit pixel>

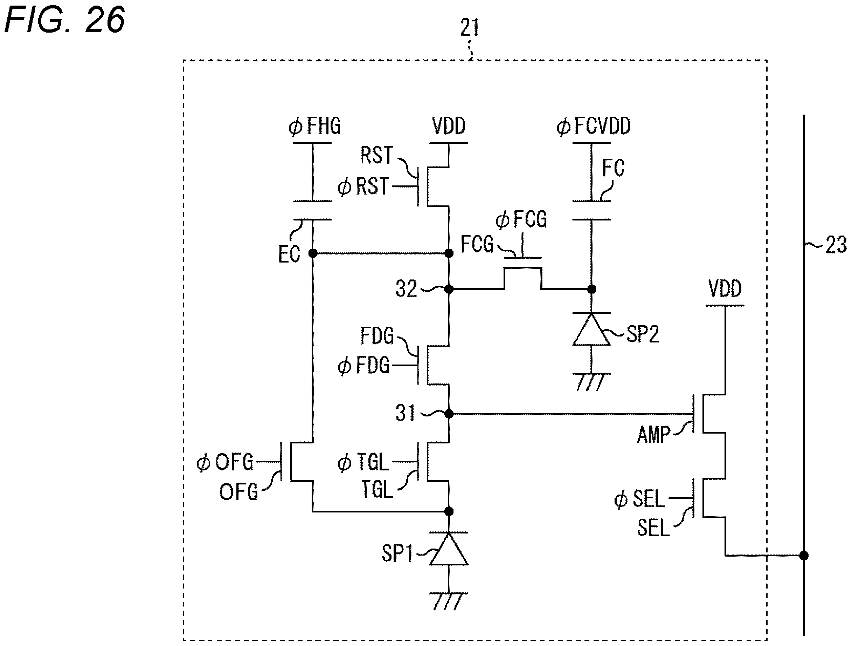

Fig. 26 is a diagram illustrating a third circuit configuration example of the unit pixel 21. In Fig. 26, portions common to those of the first circuit configuration example illustrated in Fig. 2 are denoted by the same reference numerals, and description of the portions will be omitted as appropriate.

The unit pixel 21 in Fig. 26 is different from the first circuit configuration example illustrated in Fig. 2 in that a discharge transistor OFG is newly added between the cathode terminal of the first photoelectric converter SP1 and the electrode of the first capacitive element EC on the second FD unit 32 side. The other points are similar to those of the first circuit configuration example illustrated in Fig. 2.

When the discharge transistor OFG is turned on by the discharge signal ϕOFG supplied to the gate electrode, the discharge transistor OFG transfers the charge overflowing from the first photoelectric converter SP1 to the first capacitive element EC. The discharge transistor OFG is provided, and the charge is transferred not through the first FD unit 31 and the second FD unit 32 but by the discharge transistor OFG, the amount of overflowing charge can be controlled.

### <Arrangement example of pixel transistor>

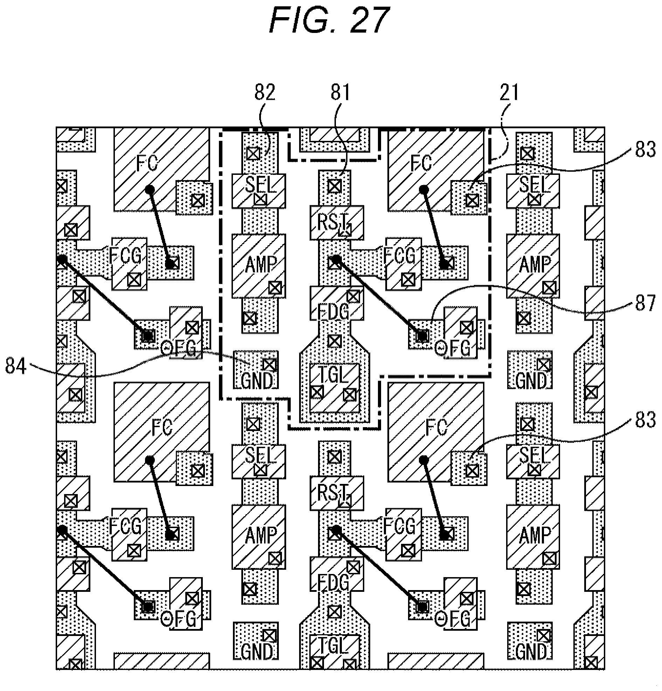

Fig. 27 is a plan view illustrating a pixel transistor arrangement example of the third circuit configuration example of the unit pixel 21. Fig. 27 corresponds to a plan view illustrating the pixel transistor arrangement of the first circuit configuration example illustrated in B of Fig. 3. Also, in Fig. 27, portions corresponding to those in the first circuit configuration example illustrated in B of Fig. 3 are denoted by the same reference numerals, and description of those portions will be omitted as appropriate.

In the third circuit configuration example of Fig. 27, the seventh active region 87 in which the discharge transistor OFG is formed is formed between the first active region 81 in which the second transfer transistor FCG of the first circuit configuration example of B of Fig. 3 is formed and the third active region 83 in which one electrode (N+ type semiconductor region 57 of Fig. 4) of the second capacitive element FC is formed. The second transfer transistor FCG is connected to the electrode of the second capacitive element FC on the lower side in the first circuit configuration example of B of Fig. 3, but is connected to the electrode of the second capacitive element FC on the upper side in the third circuit configuration example of Fig. 27.

The first active region 81, the second active region 82, and the fourth active region 84 are formed similarly to the first circuit configuration example.

### <14. Fourth circuit configuration example of unit pixel>

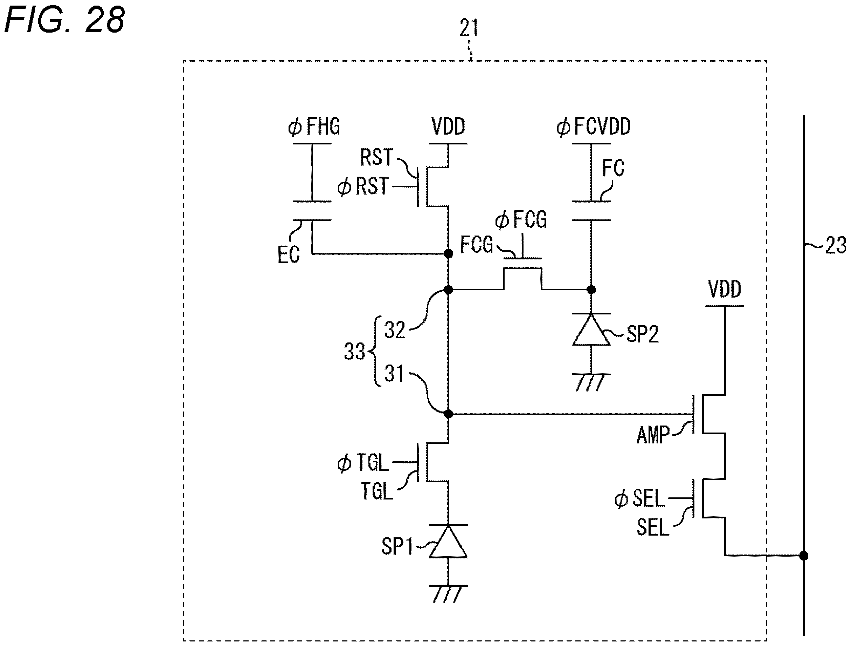

Fig. 28 is a diagram illustrating a fourth circuit configuration example of the unit pixel 21. In Fig. 28, portions common to those of the first circuit configuration example illustrated in Fig. 2 are denoted by the same reference numerals, and description of the portions will be omitted as appropriate.

The fourth circuit configuration example of the unit pixel 21 in Fig. 28 is different from the first circuit configuration example in Fig. 2 in that the switching transistor FDG arranged between the first FD unit 31 and the second FD unit 32 in the first circuit configuration example in Fig. 2 is omitted. The other points are similar to those of the first circuit configuration example illustrated in Fig. 2.

The unit pixel 21 may have a configuration in which the switching transistor FDG is omitted as illustrated in Fig. 28. In this case, the first FD unit 31 and the second FD unit 32 are formed by a diffusion layer (high-concentration semiconductor region) in the semiconductor substrate, and configure one FD unit 33. The FD unit 33 holds the charge read from the first photoelectric converter SP1 or the second photoelectric converter SP2.

The capacitance of the FD unit 33, which is the diffusion layer capacitance formed by the diffusion layer in the semiconductor substrate, is smaller than the capacitance of the first capacitive element EC formed by other than the diffusion layer. The respective capacitances are formed such that the magnitude relationship of the capacitances of the FD unit 33, the first capacitive element EC, and the second capacitive element FC is larger in the first capacitive element EC than in the FD unit 33, and is larger in the second capacitive element FC than in the first capacitive element EC, that is, the relationship of (FD unit 33) < (first capacitive element EC) < (second capacitive element FC) is satisfied. The capacitances per unit area of the first capacitive element EC and the second capacitive element FC are similar to those of the first circuit configuration example in that the second capacitive element FC is larger than the first capacitive element EC, that is, (the first capacitive element EC) < (the second capacitive element FC) is met.

### <15. Configuration example of vertical drive unit>

Next, a configuration of the vertical drive unit 12 that drives the unit pixel 21 will be described.

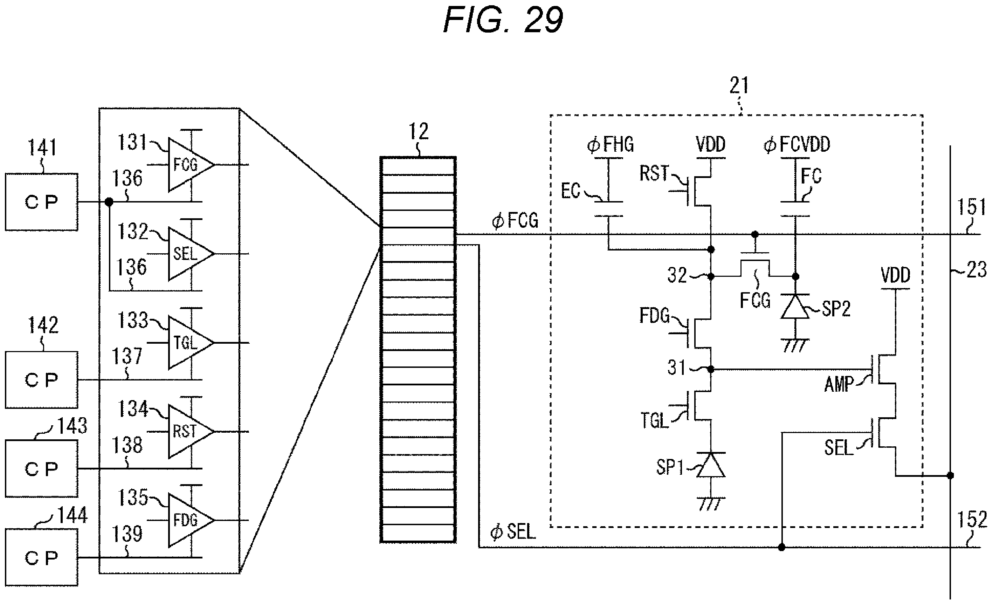

Fig. 29 illustrates a part of the configuration of the vertical drive unit 12.

The vertical drive unit 12 includes the FCG driver circuit 131, the SEL driver circuit 132, the TGL driver circuit 133, the RST driver circuit 134, and the FDG driver circuit 135, for example, in units of pixel rows of the unit pixels 21. The FCG driver circuit 131 is a circuit that outputs a second transfer drive signal ϕFCG for controlling the second transfer transistor FCG. The SEL driver circuit 132 is a circuit that outputs a selection drive signal ϕSEL for controlling the selection transistor SEL. The TGL driver circuit 133 is a circuit that outputs a first transfer drive signal ϕTGL for controlling the first transfer transistor TGL. The RST driver circuit 134 is a circuit that outputs a reset drive signal ϕRST for controlling the reset transistor RST. The FDG driver circuit 135 is a circuit that outputs a capacitance switching signal ϕFDG for controlling the switching transistor FDG.

The vertical drive unit 12 supplies the second transfer drive signal ϕFCG generated by the FCG driver circuit 131 to the gate electrode of the second transfer transistor FCG of the unit pixel 21 of the same pixel row through the drive wiring 151. In addition, the vertical drive unit 12 supplies the selection drive signal ϕSEL generated by the SEL driver circuit 132 to the gate electrode of the selection transistor SEL of the unit pixel 21 of the same pixel row through the drive wiring 152. The drive wiring for supplying the first transfer drive signal ϕTGL, the capacitance switching signal ϕFDG, and the reset drive signal ϕRST to the unit pixel 21 is omitted.

The charge pump circuit 141 generates OFF voltages of the second transfer drive signal ϕFCG and the selection drive signal ϕSEL, and supplies the OFF voltages to the FCG driver circuit 131 and the SEL driver circuit 132 through the same supply wiring 136.

The charge pump circuit 142 generates an OFF voltage of the first transfer drive signal ϕTGL and supplies the OFF voltage to the TGL driver circuit 133 through the supply wiring 137.

The charge pump circuit 143 generates an OFF voltage of the reset drive signal ϕRST, and supplies the OFF voltage to the RST driver circuit 134 through the supply wiring 138.

The charge pump circuit 144 generates an OFF voltage of the capacitance switching signal ϕFDG and supplies the OFF voltage to the FDG driver circuit 135 through the supply wiring 139.

The OFF voltages of the first transfer drive signal ϕTGL, the reset drive signal ϕRST, and the capacitance switching signal ϕFDG are supplied from the charge pump circuits 142 to 144 provided on a one-to-one basis, but the OFF voltages of the second transfer drive signal ϕFCG and the selection drive signal ϕSEL are supplied from one charge pump circuit 141. The OFF voltages of the second transfer drive signal ϕFCG and the selection drive signal ϕSEL are negative bias values.

In the unit pixel 21 having two capacitances of the first capacitive element EC and the second capacitive element FC, the pixel transistors whose OFF voltages are desired to be enhanced are the selection transistor SEL and the second transfer transistor FCG. Even when the capacitance of the first capacitive element EC is large, the selection transistor SEL is not affected by the accumulated charge of the first capacitive element EC, and it is necessary to enhance the selection transistor SEL in order to reliably separate the selection and non-selection of the pixel row from the other pixel rows. The second transfer transistor FCG needs to be enhanced because the accumulated charge of the second photoelectric converter SP2 increases. Therefore, in the unit pixel 21, the OFF voltages of the selection transistor SEL and the second transfer transistor FCG are controlled to voltages lower than the OFF voltages of the other pixel transistors, that is, the first transfer transistor TGL, the reset transistor RST, and the switching transistor FDG ((OFF voltage of selection transistor SEL and second transfer transistor FCG) < (OFF voltage of other pixel transistor)).

Therefore, in the solid-state imaging device 1, the charge pump circuit that generates the OFF voltage of the selection transistor SEL and the second transfer transistor FCG of which the OFF voltage is desired to be enhanced is made common. The solid-state imaging device 1 generates a negative bias for determining the OFF voltages of the second transfer drive signal ϕFCG and the selection drive signal ϕSEL by one charge pump circuit 141, and supplies the negative bias to the FCG driver circuit 131 and the SEL driver circuit 132 through the common supply wiring 136. As a result, it is possible to reduce one charge pump circuit, reduce a circuit area, and reduce a chip size.

For example, by commonalizing the negative bias of the OFF voltage of the selection transistor SEL with the OFF voltage of the second transfer transistor FCG, the saturation charge amount of the first capacitive element EC can be increased by about 50 mV (about 1430e) as compared with the case of commonality with the OFF voltage of the first transfer transistor TGL.

### <16. Usage example of image sensor>

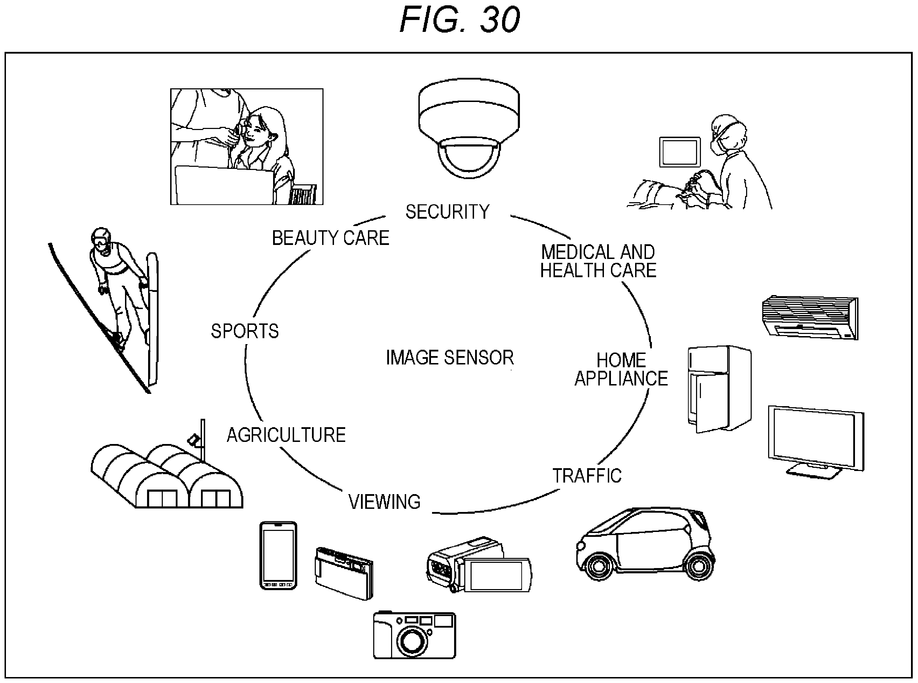

Fig. 30 is a diagram illustrating a usage example of an image sensor using the above-described solid-state imaging device 1.

The above-described solid-state imaging device 1 can be used as an image sensor in various cases of sensing light such as visible light, infrared light, ultraviolet light, and X-rays as described below, for example.

· A device that captures an image to be used for viewing, such as a digital camera and a portable device with a camera function.
· A device for traffic purpose such as an in-vehicle sensor which takes images of the front, rear, surroundings, interior and the like of an automobile, a surveillance camera for monitoring traveling vehicles and roads, and a ranging sensor which measures a distance between vehicles and the like for safe driving such as automatic stop, recognition of a driver's condition and the like.
· A device for home appliance such as a television (TV), a refrigerator, and an air conditioner that images a user's gesture and performs device operation according to the gesture
· A device for medical and health care use such as an endoscope and a device that performs angiography by receiving infrared light
· A device for security use such as a security monitoring camera and an individual authentication camera
· A device used for beauty care, such as a skin condition measuring instrument for imaging skin, and a microscope for imaging the scalp
· A device used for sports, such as an action camera or a wearable camera for sports applications or the like
· A device used for agriculture, such as a camera for monitoring a condition of a field or crop.

### <17. Application example to electronic device>

Application of the technology of the present disclosure is not limited to that to the solid-state imaging device. That is to say, the technology of the present disclosure may be generally applied to electronic devices in which the solid-state imaging device is used in an image capturing unit (photoelectric converting unit) such as an imaging device such as a digital still camera and a video camera, a portable terminal device having an imaging function, and a copying machine in which the solid-state imaging device is used in the image reading unit. The solid-state imaging device may be formed as one chip, or may be in a module form having an imaging function in which an imaging section and a signal processing unit or an optical system are packaged together.

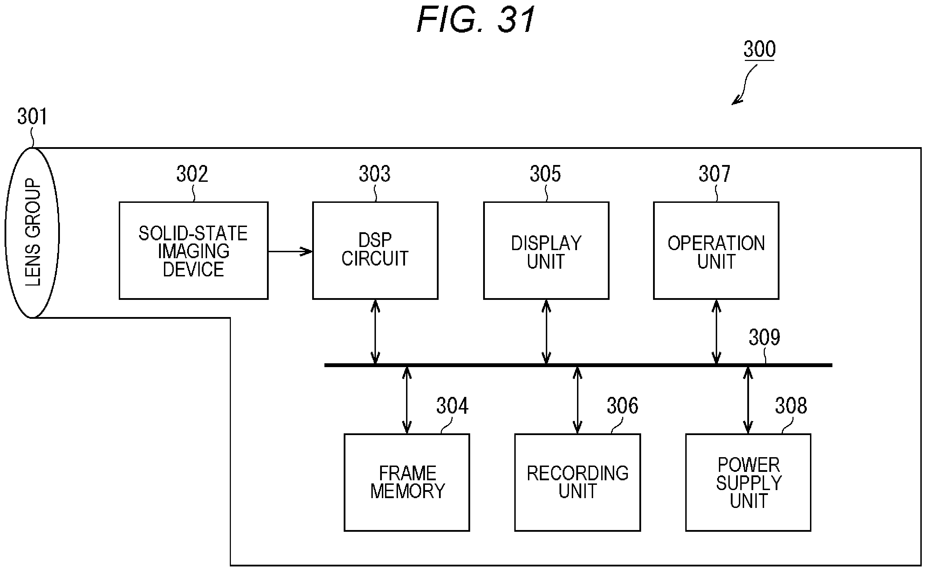

Fig. 31 is a block diagram illustrating a configuration example of an imaging device as an electronic device to which the technology of the present disclosure is applied.

An imaging device 300 in Fig. 31 includes an optical unit 301 including a lens group and the like, a solid-state imaging device (imaging device) 302 in which the configuration of the solid-state imaging device 1 in Fig. 1 is adopted, and a digital signal processor (DSP) circuit 303 that is a camera signal processing circuit. Furthermore, the imaging device 300 includes a frame memory 304, a display unit 305, a recording unit 306, an operation unit 307, and a power supply unit 308. The DSP circuit 303, the frame memory 304, the display unit 305, the recording unit 306, the operation unit 307, and the power supply unit 308 are connected to one another through a bus line 309.

The optical unit 301 captures incident light (image light) from a subject and forms an image on an imaging surface of the solid-state imaging device 302. The solid-state imaging device 302 converts the light amount of the incident light imaged on the imaging surface by the optical unit 301 into an electrical signal in units of pixels and outputs the electrical signal as a pixel signal. As the solid-state imaging device 302, the solid-state imaging device 1 of Fig. 1, that is, a solid-state imaging device including a unit pixel 21 including a first photoelectric converter SP1 and a second photoelectric converter SP2 having different sensitivities, and two capacitive elements that accumulate charges generated in the first photoelectric converter SP1 and the second photoelectric converter SP2, specifically, a first capacitive element EC that accumulates charges generated in the first photoelectric converter SP1, and a second capacitive element FC that accumulates charges generated in the second photoelectric converter SP2 is used.

For example, the display unit 305 includes a thin display such as a liquid crystal display (LCD) or an organic electro luminescence (EL) display, and displays a moving image or a still image captured by the solid-state imaging device 302. The recording unit 306 records a moving image or a still image captured by the solid-state imaging device 302 on a recording medium such as a hard disk or a semiconductor memory.

The operation unit 307 issues an operation command regarding various functions of the imaging device 300 under operation by a user. The power supply unit 308 appropriately supplies various power to be operation power supply for the DSP circuit 303, the frame memory 304, the display unit 305, the recording unit 306, and the operation unit 307, to these supply targets.

As described above, with use of the solid-state imaging device 1 in which the unit pixels 21 each including the two photoelectric converters having different sensitivities and the two capacitive elements are two-dimensionally arranged in a matrix as the solid-state imaging device 302, noise can be reduced and a dynamic range can be expanded. Therefore, even in the imaging device 300 such as a video camera, a digital still camera, or a camera module for a mobile device such as a mobile phone, a high-quality captured image can be acquired at high speed.

An example in which the technology of the present disclosure is applied to a solid-state imaging device that outputs an image signal has been described. However, the technology of the present disclosure can be applied not only to a solid-state imaging device but also to all photodetection devices including pixels that receive and photoelectrically convert incident light. For example, the present invention can also be applied to a light receiving device (distance measuring sensor) of a distance measuring system that receives infrared light emitted as active light and measures a distance to a subject by a direct ToF method or an indirect ToF method. Further, the present disclosure is not limited to application to a solid-state imaging device that detects distribution of the amount of incident light of visible light and captures the distribution as an image, and can be applied to all solid-state imaging devices (physical quantity distribution detection devices) such as a solid-state imaging device that captures distribution of the amount of incident infrared rays, X-rays, particles, or the like as an image, a fingerprint detection sensor that detects distribution of other physical quantities such as pressure, capacitance, and the like, and captures the distribution as an image in a broad sense, and the like.

### <18. Application example to mobile body>

The technology according to the present disclosure (present technology) may be applied to various products. For example, the technology according to the present disclosure may be implemented as a device mounted on any type of mobile body such as an automobile, an electric vehicle, a hybrid electric vehicle, a motorcycle, a bicycle, a personal mobility, an airplane, a drone, a ship, a robot, and the like.

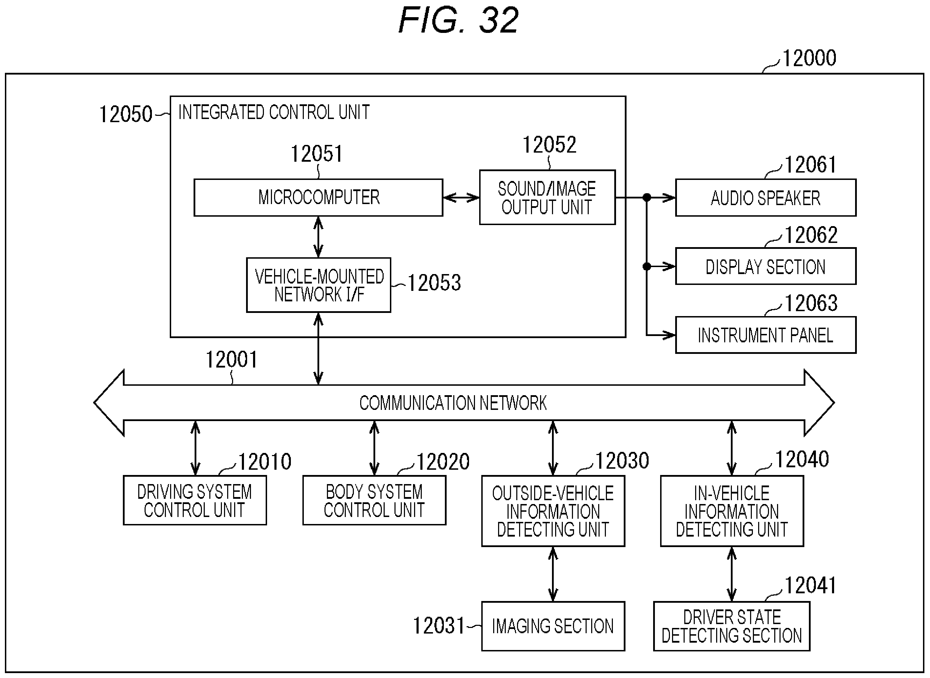

Fig. 32 is a block diagram illustrating a schematic configuration example of a vehicle control system which is an example of a mobile body control system to which the technology according to the present disclosure can be applied.

The vehicle control system 12000 includes a plurality of electronic control units connected to each other via a communication network 12001. In the example illustrated in Fig. 32, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 32, an audio speaker 12061, a display section 12062, and an instrument panel 12063 are illustrated as the output device. The display section 12062 may, for example, include at least one of an on-board display and a head-up display.

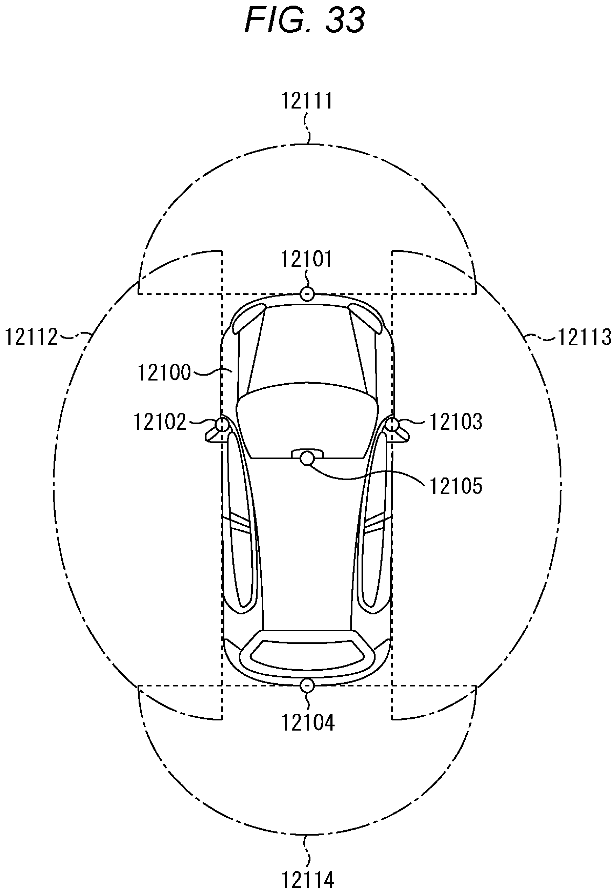

Fig. 33 is a diagram illustrating an example of the installation position of the imaging section 12031.

In Fig. 33, a vehicle 12100 includes imaging sections 12101, 12102, 12103, 12104, and 12105, as the imaging section 12031.

The imaging sections 12101, 12102, 12103, 12104, 12105 are provided, for example, at positions such as a front nose, a sideview mirror, a rear bumper, a back door, and an upper portion of a windshield in the interior of a vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The images of the front thereof obtained by the imaging sections 12101 and 12105 are mainly used to detect a preceding vehicle, a pedestrian, an obstacle, a traffic signal, a traffic sign, a lane, or the like.

Note that Fig. 33 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure is applicable has been described above. The technology according to the present disclosure may be applied to the imaging section 12031 out of the configurations described above. Specifically, the solid-state imaging device 1 described above can be applied as the imaging section 12031. By applying the technology according to the present disclosure to the imaging section 12031, it is possible to obtain a more easily viewed taken image and obtain distance information while reducing the size. Furthermore, it is possible to reduce driver's fatigue and increase the safety of the driver and the vehicle by using the obtained captured image and distance information.

In the above-described example, the solid-state imaging device in which the first conductivity type is the P-type, the second conductivity type is the N-type, and electrons are used as signal charges has been described, but the present disclosure can also be applied to a solid-state imaging device in which holes are used as signal charges. That is, the first conductivity type may be the N-type, the second conductivity type may be the P-type, and the conductivity types of the above-described respective semiconductor regions may be reversed.

The embodiment of the present disclosure is not limited to the above-described embodiments and various modifications may be made without departing from the gist of the technology of the present disclosure.

The effects described in the present specification are merely examples and are not limited, and effects other than those described in the present specification may be provided.

Note that the technique of the present disclosure can have the following configurations.
(1) A solid-state imaging device including
   a unit pixel, the unit pixel including:
   a first photoelectric converter having a first sensitivity;
   a second photoelectric converter having a second sensitivity lower than the first sensitivity;
   a first capacitive element connected to the first photoelectric converter; and
   a second capacitive element connected to the second photoelectric converter.
(2) The solid-state imaging device according to the above (1), in which
   the first capacitive element includes a diffusion layer capacitance formed of a diffusion layer and a capacitance other than the diffusion layer capacitance, and
   a magnitude relationship of the capacitances has the following relationship:
      (the diffusion layer capacitance of the first capacitive element) < (a capacitance other than the diffusion layer capacitance of the first capacitive element) < (a capacitance other than the diffusion layer capacitance of the first capacitive element) < (a capacitance of the second capacitive element)
(3) The solid-state imaging device according to the above (1) or (2), in which
   the first capacitive element includes a diffusion layer capacitance formed of a diffusion layer and a capacitance other than the diffusion layer capacitance, and
   the capacitance per unit area has the following relationship:
      (capacitance other than the diffusion layer capacitance of the first capacitive element) < (capacitance of the second capacitive element)
(4) The solid-state imaging device according to any one of the above (1) to (3), in which
   the first capacitive element includes a diffusion layer capacitance formed of a diffusion layer and a capacitance other than the diffusion layer capacitance, and
   a capacitance other than the diffusion layer capacitance of the first capacitive element and the second capacitive element are arranged in different layers.
(5) The solid-state imaging device according to any one of the above (1) to (4), in which
   the first capacitive element includes a diffusion layer capacitance formed of a diffusion layer and a capacitance other than the diffusion layer capacitance, and
   a capacitance other than the diffusion layer capacitance of the first capacitive element is configured by a wiring capacitance formed in a plurality of wiring layers.
(6) The solid-state imaging device according to the above (5), in which
   the wiring capacitance includes a comb-shaped metal wiring line.
(7) The solid-state imaging device according to the above (5) or (6), in which
   the plurality of wiring layers includes a wiring layer as a shield layer on a further upper side of the wiring layer in which the wiring capacitance is formed.
(8) The solid-state imaging device according to any one of the above (1) to (7), in which
   the second capacitive element includes a MOS capacitance.
(9) The solid-state imaging device according to any one of the above (4) to (8), in which
   the first capacitive element includes a MOS capacitance, and the second capacitive element includes a MIM capacitance.
(10) The solid-state imaging device according to any one of the above (4) to (9), in which
   the first capacitive element includes a MIM capacitance, and the second capacitive element includes a MIM capacitance.
(11) The solid-state imaging device according to any one of the above (1) to (10), in which
   the unit pixel further includes a switching transistor that switches conversion efficiency.
(12) The solid-state imaging device according to any one of the above (1) to (11), in which
   the unit pixel further includes a transfer transistor that transfers charge generated by the second photoelectric converter to the second capacitive element between the second photoelectric converter and the second capacitive element.
(13) The solid-state imaging device according to any one of the above (1) to (12), in which
   the unit pixel further includes a discharge transistor that transfers a charge overflowing from the first photoelectric converter to the first capacitive element.
(14) The solid-state imaging device according to any one of the above (1) to (13), in which
   a mode is provided in which the unit pixel outputs three or more different signals by single exposure.
(15) The solid-state imaging device according to the above (14), in which
   at least one of the three or more different signals is a signal corresponding to an accumulated charge of the first capacitive element.
(16) The solid-state imaging device according to the above (14) or (15), in which
   a mode of reading a signal of the first photoelectric converter with different conversion efficiency and a mode of outputting a signal corresponding to an accumulated charge of the first capacitive element are provided as the mode.
(17) The solid-state imaging device according to any one of the above (14) to (16), in which
   a first mode and a second mode for outputting low illuminance sensitivity with different sensitivities are provided as the mode.
(18) The solid-state imaging device according to any one of the above (14) to (17), further including
   a control section configured to switch between two modes in which three or more different signals are output by single exposure in conjunction with a temperature.
(19) The solid-state imaging device according to any one of the above (14) to (17), in which
   as the mode, a mode is provided for outputting a signal obtained by detecting the charge of the first photoelectric converter with a first conversion efficiency, a signal obtained by detecting the charge of the first photoelectric converter with a second conversion efficiency, a signal corresponding to the accumulated charge of the first capacitive element, and a signal detected by the second photoelectric converter.
(20) The solid-state imaging device according to any one of the above (1) to (17), in which
   as the mode, a mode is provided for outputting a signal obtained by detecting a charge of the first photoelectric converter with a first conversion efficiency, a signal obtained by detecting a charge of the first photoelectric converter with a second conversion efficiency, a signal corresponding to an accumulated charge of only the second photoelectric converter, and a signal corresponding to an accumulated charge including the second capacitive element.
(21) The solid-state imaging device according to any one of the above (1) to (17), in which
   the unit pixel includes:
   a selection transistor that selects the unit pixel; and
   a transfer transistor that transfers the charge generated by the second photoelectric converter,
   the solid-state imaging device further comprises:
      a first driver circuit that outputs a selection drive signal for controlling the selection transistor; and
      a second driver circuit that outputs a transfer drive signal for controlling the transfer transistor, and

OFF voltages of the selection drive signal and the transfer drive signal are supplied to the first driver circuit and the second driver circuit by common supply wiring.

(22) The solid-state imaging device according to the above (21), in which
OFF voltages of the selection drive signal and the transfer drive signal are negative bias values, and
a negative bias value of an OFF voltage of the selection drive signal and the transfer drive signal is a voltage lower than an OFF voltage of a drive signal for controlling another pixel transistor in the unit pixel.

(23) An electronic device including
a solid-state imaging device having
a unit pixel, the unit pixel including:
   a first photoelectric converter having a first sensitivity;
   a second photoelectric converter having a second sensitivity lower than the first sensitivity;
   a first capacitive element connected to the first photoelectric converter; and
   a second capacitive element connected to the second photoelectric converter.

### REFERENCE SIGNS LIST

- 1: Solid-state imaging device
- 11: Pixel array unit
- 12: Vertical driving unit
- 21: Unit pixel
- TGL: First transfer transistor
- SP1: First photoelectric converter
- SP2: Second photoelectric converter
- EC: First capacitive element
- FC: Second capacitive element
- 31: First FD unit
- 32: Second FD unit
- 33: FD unit
- FCG: Second transfer transistor
- FDG: Switching transistor
- RST: Reset transistor
- SEL: Selection transistor
- OFG: Discharge transistor
- TGS: Third transfer transistor
- 71: Multilayer wiring layer
- 72: Metal wiring line
- 73: Interlayer insulating film
- 74: Polysilicon electrode
- 131: FCG driver circuit
- 132: SEL driver circuit
- 133: TGL driver circuit
- 134: RST driver circuit
- 135: FDG driver circuit
- 136: Supply wiring
- 141: Charge pump circuit
- 300: Imaging device
- 302: Solid-state imaging device
- AMP: Amplification transistor
- EC_{M1} to EC_{M4}: Metal wiring line
- M1: First wiring layer
- M2: Second wiring layer
- M3: Third wiring layer
- M4: Fourth wiring layer
- M5: Fifth wiring layer
- ϕFCG: Second transfer drive signal
- ϕFCVDD: Voltage
- ϕFDG: Capacitance switching signal
- ϕFHG: Voltage
- ϕOFG: Discharge signal
- ϕRST: Reset drive signal
- ϕSEL: Selection drive signal
- ϕTGL: First transfer drive signal
- ϕTGS: Third transfer drive signal

## Claims

1. A solid-state imaging device including
a unit pixel, the unit pixel comprising:
a first photoelectric converter having a first sensitivity;
a second photoelectric converter having a second sensitivity lower than the first sensitivity;
a first capacitive element connected to the first photoelectric converter; and
a second capacitive element connected to the second photoelectric converter.

2. The solid-state imaging device according to claim 1, wherein
the first capacitive element includes a diffusion layer capacitance formed of a diffusion layer and a capacitance other than the diffusion layer capacitance, and
a magnitude relationship of the capacitances has the following relationship:
(the diffusion layer capacitance of the first capacitive element) < (a capacitance other than the diffusion layer capacitance of the first capacitive element) < (a capacitance other than the diffusion layer capacitance of the first capacitive element) < (a capacitance of the second capacitive element).

3. The solid-state imaging device according to claim 1, wherein
the first capacitive element includes a diffusion layer capacitance formed of a diffusion layer and a capacitance other than the diffusion layer capacitance, and
the capacitance per unit area has the following relationship:
(capacitance other than the diffusion layer capacitance of the first capacitive element) < (capacitance of the second capacitive element).

4. The solid-state imaging device according to claim 1, wherein
the first capacitive element includes a diffusion layer capacitance formed of a diffusion layer and a capacitance other than the diffusion layer capacitance, and
a capacitance other than the diffusion layer capacitance of the first capacitive element and the second capacitive element are arranged in different layers.

5. The solid-state imaging device according to claim 1, wherein
the first capacitive element includes a diffusion layer capacitance formed of a diffusion layer and a capacitance other than the diffusion layer capacitance, and
a capacitance other than the diffusion layer capacitance of the first capacitive element is configured by a wiring capacitance formed in a plurality of wiring layers.

6. The solid-state imaging device according to claim 5, wherein
the wiring capacitance includes a comb-shaped metal wiring line.

7. The solid-state imaging device according to claim 5, wherein
the plurality of wiring layers includes a wiring layer as a shield layer on a further upper side of the wiring layer in which the wiring capacitance is formed.

8. The solid-state imaging device according to claim 1, wherein
the second capacitive element includes a MOS capacitance.

9. The solid-state imaging device according to claim 1, wherein
the first capacitive element includes a MOS capacitance, and the second capacitive element includes a MIM capacitance.

10. The solid-state imaging device according to claim 1, wherein
the first capacitive element includes a MIM capacitance, and the second capacitive element includes a MIM capacitance.

11. The solid-state imaging device according to claim 1, wherein
the unit pixel further includes a switching transistor that switches conversion efficiency.

12. The solid-state imaging device according to claim 1, wherein
the unit pixel further includes a transfer transistor that transfers charge generated by the second photoelectric converter to the second capacitive element between the second photoelectric converter and the second capacitive element.

13. The solid-state imaging device according to claim 1, wherein
the unit pixel further includes a discharge transistor that transfers a charge overflowing from the first photoelectric converter to the first capacitive element.

14. The solid-state imaging device according to claim 1, wherein
a mode is provided in which the unit pixel outputs three or more different signals by single exposure.

15. The solid-state imaging device according to claim 14, wherein
at least one of the three or more different signals is a signal corresponding to an accumulated charge of the first capacitive element.

16. The solid-state imaging device according to claim 14, wherein
a mode of reading a signal of the first photoelectric converter with different conversion efficiency and a mode of outputting a signal corresponding to an accumulated charge of the first capacitive element are provided as the mode.

17. The solid-state imaging device according to claim 14, wherein
a first mode and a second mode for outputting low illuminance sensitivity with different sensitivities are provided as the mode.

18. The solid-state imaging device according to claim 14, further comprising
a control section configured to switch between two modes in which three or more different signals are output by single exposure in conjunction with a temperature.

19. The solid-state imaging device according to claim 14, wherein
as the mode, a mode is provided for outputting a signal obtained by detecting the charge of the first photoelectric converter with a first conversion efficiency, a signal obtained by detecting the charge of the first photoelectric converter with a second conversion efficiency, a signal corresponding to the accumulated charge of the first capacitive element, and a signal detected by the second photoelectric converter.

20. The solid-state imaging device according to claim 14, wherein
as the mode, a mode is provided for outputting a signal obtained by detecting a charge of the first photoelectric converter with a first conversion efficiency, a signal obtained by detecting a charge of the first photoelectric converter with a second conversion efficiency, a signal corresponding to an accumulated charge of only the second photoelectric converter, and a signal corresponding to an accumulated charge including the second capacitive element.

21. The solid-state imaging device according to claim 1, wherein
the unit pixel includes:
a selection transistor that selects the unit pixel; and
a transfer transistor that transfers the charge generated by the second photoelectric converter,
the solid-state imaging device further comprises:
a first driver circuit that outputs a selection drive signal for controlling the selection transistor; and
a second driver circuit that outputs a transfer drive signal for controlling the transfer transistor, and
OFF voltages of the selection drive signal and the transfer drive signal are supplied to the first driver circuit and the second driver circuit by common supply wiring.

22. The solid-state imaging device according to claim 21, wherein
OFF voltages of the selection drive signal and the transfer drive signal are negative bias values, and
a negative bias value of an OFF voltage of the selection drive signal and the transfer drive signal is a voltage lower than an OFF voltage of a drive signal for controlling another pixel transistor in the unit pixel.

23. An electronic device including
a solid-state imaging device having
a unit pixel, the unit pixel comprising:
a first photoelectric converter having a first sensitivity;
a second photoelectric converter having a second sensitivity lower than the first sensitivity;
a first capacitive element connected to the first photoelectric converter; and
a second capacitive element connected to the second photoelectric converter.
